# EUROPEAN PATENT SPECIFICATION

(11) **EP 4 227 983 B1**
(45) Date of publication and mention of the grant of the patent: **20.11.2024**
(21) Application number: 23156402.2
(22) Date of filing: 13.02.2023
(51) Int. Cl.: H01L 21/67

(54) **SUBSTRATE TREATING APPARATUS, SUBSTRATE TREATING SYSTEM, AND SUBSTRATE TREATING METHOD**
SUBSTRATBEHANDLUNGSVORRICHTUNG, SUBSTRATBEHANDLUNGSSYSTEM UND SUBSTRATBEHANDLUNGSVERFAHREN
APPAREIL DE TRAITEMENT DE SUBSTRAT, SYSTÈME DE TRAITEMENT DE SUBSTRAT ET PROCÉDÉ DE TRAITEMENT DE SUBSTRAT

(30) Priority: 14.02.2022 JP 2022020358
(43) Date of publication of application: 16.08.2023
(73) Proprietor: SCREEN Holdings Co., Ltd., Kyoto-shi, Kyoto 602-8585 (JP)
(72) Inventor: SHIMIZU, Shinji, Kyoto-shi, 602-8585 (JP); MINOGUCHI, Akihiro, Kyoto-shi, 602-8585 (JP)
(74) Representative: Kilian Kilian & Partner mbB

(56) References cited:
- JP-A- 2020 034 344

## Description

### BACKGROUND OF THE INVENTION

### 1. Field of the Invention

The present invention relates to a substrate treating apparatus, a substrate treating system, and a substrate treating method for performing a predetermined treatment on a substrate, such as a semiconductor substrate, a substrate for flat panel display (FPD) like liquid crystal display and organic electroluminescence (EL) display, a glass substrate for photomask, and an optical disk substrate. Particularly, the present invention relates to a technique for detecting an abnormality or an operational status of a component.

### 2. Description of the Related Art

Examples of currently-used apparatus of this type include one provided with a treatment chamber, a substrate holder, a nozzle, a camera, an image processing unit, and a monitoring unit. See, for example, International Patent Application Publication No. WO2019/146456. JP2020034344 discloses a moving part position detection method, a substrate processing method, a substrate processing apparatus and a substrate processing system.

This apparatus includes the substrate holder, the nozzle, and the camera provided in the treatment chamber. The substrate holder holds a substrate to be treated in a horizontal posture. The substrate holder rotates the substrate in a horizontal plane. The nozzle has a distal end moved between an origin position apart laterally of the substrate and an ejecting position above the substrate. The distal end of the nozzle is moved from the origin position to the ejecting position for every substrate treatment, and supplies a treatment liquid to the substrate. The camera is attached to a predetermined position within the treatment chamber, and images a predetermined area including the distal end of the nozzle moved to the ejecting position every treatment.

The monitoring unit stores first nozzle position information, based on information from a rotation control system, in advance as positional information when the distal end of the nozzle is located at a normal ejecting position. The image processing unit obtains second nozzle position information, representing a nozzle position, based on an image of the distal end of the nozzle captured by the camera, and outputs the second nozzle position information to the monitoring unit. The monitoring unit monitors presence/absence of an abnormality at the position of the distal end of the nozzle, based on the correspondence between the first nozzle position information and the second nozzle position information.

However, the example of the currently-used apparatus with such a construction has the following problems. Specifically, the currently-used apparatus compares the first nozzle position information based on the information from the rotation control system with the captured second nozzle position information. Accordingly, the captured image changes when the environment at the time of imaging, a light source, or water droplets and fumes (e.g., dust particles, hazes, vapors, and volatile particles generated through heating or sublimation of materials) change. Consequently, it is impossible to obtain correct positional information accurately based on the captured image. As a result, such a drawback arises that the abnormality of the nozzle position cannot be detected accurately from the comparison between the first nozzle position information and the second nozzle position information.

Moreover, it is proposed that, instead of the first nozzle position information based on the information from the rotation control system, an image obtained by imaging in advance the nozzle moved to the correct ejecting position be used as a reference image. However, when there is a large difference in imaging condition between the reference image and the second nozzle position information, it is impossible to accurately determine whether the difference occurs due to an abnormality even if there is a difference between the reference image and the second nozzle position information. Accordingly, such a drawback is still present that the abnormality of the nozzle position cannot be detected accurately.

### SUMMARY OF THE INVENTION

The present invention has been made regarding the state of the art noted above, and its object is to provide a substrate treating apparatus, a substrate treating system and a substrate treating method that can detect an abnormality of a component accurately with use of design information.

The present invention is constituted as stated below to achieve the above object.

One aspect of the present invention provides a substrate treating apparatus for performing a predetermined treatment on a substrate. The apparatus includes: a design information memory unit configured to store three-dimensional design information about at least target components to be detected for an abnormality; an imaging unit configured to capture a real image including the target components; a matching processing unit configured to determine which of the target components matches a real image shape as a two-dimensional shape in the real image captured by the imaging unit in accordance with a degree of coincidence of feature points between the real image shape and a two-dimensional design shape based on three-dimensional design information about the target components; and an abnormality detecting unit configured to detect an abnormality of a target component, matched in the matching processing unit, through comparison between reality information about the matched target component based on the real image and normal information based on three-dimensional design information when the matched target component is normal.

With the aspect of the present invention, the matching processing unit determines which of the target components matches the real image shape in accordance with the degree of coincidence of feature points between the real image shape and the design shape. The matching processing unit performs the matching in accordance with the degree of coincidence of the feature points. Accordingly, the matching can be performed while minimizing an environment difference upon imaging and an influence of a light source, water droplets, or fumes. The abnormality detecting unit detects an abnormality of the target component through comparison between the reality information about the matched target component based on the real image and the normal information based on the three-dimensional design information when the target component is normal. Consequently, matching accuracy is enhanced, and thus the abnormality detecting unit can detect an abnormality of the target component accurately. Moreover, even if part of the target component is invisible during imaging, matching can be performed as long as the feature point appears in the real image shape. This can minimize an influence of the positional relationship between the target component and other components.

Moreover, it is preferred in the aspect of the present invention that the abnormality detecting unit sets the normal information based on three-dimensional design information of the target component when the target component is located within a tolerance where the target component is acceptable as normal.

Since the normal information is set within the tolerance, processing errors and variations in assembly accuracy of the target component can be absorbed. Consequently, this can prevent false detection of an abnormality caused by the processing errors and assembly errors.

Moreover, it is preferred in the aspect of the present invention that the substrate treating apparatus further includes a spin chuck configured to support the substrate in a horizontal posture and rotate the substrate, a nozzle configured to eject a treatment liquid from its distal end to the substrate supported by the spin chuck, and a nozzle moving mechanism configured to move the distal end of the nozzle between an origin position laterally apart from the substrate and an ejecting position above the substrate, and that the target component is the nozzle and the matching processing unit performs the matching at a timing set so as for the nozzle to be located at the ejecting position.

An abnormality that the nozzle is out of the ejecting position or an abnormality that the nozzle is deformed can be detected when the nozzle moving mechanism moves the nozzle that supplies the treatment liquid to the substrate supported by the spin chuck.

Moreover, it is preferred in the aspect of the present invention that the substrate treating apparatus further includes a nozzle pulse output unit configured to output a pulse when the nozzle is moved from the origin position to the ejecting position, and a nozzle movement control unit configured to control the nozzle moving mechanism in accordance with the pulse from the nozzle pulse output unit, and that the nozzle movement control unit causes the matching processing unit to perform the matching only once at such a timing that the nozzle moving mechanism sets the distal end of the nozzle to be located at the origin position, and performs correlation of the design information corresponding to the design shape matched at the time with the pulse at the origin position, and the abnormality detecting unit sets the normal information in accordance with the correlation and the pulse at the ejecting position.

The nozzle movement control unit causes the matching processing unit to perform matching only once at such a timing that the nozzle moving mechanism sets the distal end of the nozzle to be located at the origin position, and performs the correlation of the design information corresponding to the design shape matched at the time with the pulse at the origin position. The abnormality detecting unit sets the normal information at the ejecting position in accordance with the correlation and the pulse. Consequently, the normal information about the ejecting position that is moved from the origin position by the nozzle moving mechanism at a given number of pulses can be made accurate and suitable for abnormality determination. Also, false determination due to the assembly errors can be prevented.

Moreover, it is preferred in the aspect of the present invention that the spin chuck includes at its peripheral edge a plurality of chucks each having a back face supporting portion for supporting a back face of the substrate and a periphery edge supporting portion erected outside of a rotation center of the back face supporting portion for supporting a periphery edge of the substrate, and further includes a chuck drive mechanism configured to rotate the plurality of chucks in response to a chuck operation command so as for the periphery edge supporting portion not to contact the periphery edge of the substrate at an open position where the substrate is loaded and unloaded and to rotate so as for the periphery edge supporting portion to contact the periphery edge of the substrate at a closed position where the substrate is supported, and that the target component is the chucks and the matching processing unit performs the matching at a timing set so as to operate in response to the chuck operation command.

An abnormality that the periphery edge supporting portion of the chuck is not located at either the open position or the closed position or an abnormality that the periphery edge supporting portion is deformed can be detected when the chuck drive mechanism rotates the chucks between the open position and the closed position in response to the chuck operation command.

Moreover, it is preferred in the aspect of the present invention that the matching processing unit performs the matching only once at a position as the origin position where the chuck drive mechanism rotates each of the chucks to the closed position while the substrate is not placed on the chucks, and that the abnormality detecting unit sets the normal information in accordance with the design information corresponding to the design shape matched at that time.

The matching processing unit performs matching only once at a position as the origin position where the chuck drive mechanism rotates the chucks to the closed position while the substrate is not placed on the chucks. Then, the abnormality detecting unit sets the normal information in accordance with the design information corresponding to the design shape matched at that time. Consequently, the normal information can be made accurate and suitable for abnormality determination. Also, false determination due to the assembly errors can be prevented.

Moreover, it is preferred in the aspect of the present invention that the substrate treating apparatus further includes a guard configured to guard the spin chuck laterally, and a guard moving mechanism configured to move the guard upward and downward between an origin position where an upper end of the guard is low and a treating position where the upper end of the guard is higher than the origin position, and that the target component is the guard and the matching processing unit performs the matching at a timing set such that the guard is located at the treating position.

An abnormality that the guard is shifted from the origin position or the treating position or an abnormality that a shape of the guard is deformed can be detected when the guard moving mechanism moves the guard upward and downward between the origin position and the treating position.

Moreover, it is preferred in the aspect of the present invention that the matching processing unit performs the matching only once at such a timing that the guard moving mechanism sets the guard to be located at the origin position , and that the abnormality detecting unit sets the normal information in accordance with the design information corresponding to the design shape matched at that time.

The matching processing unit performs matching only once at such a timing that the guard moving mechanism sets the guard to be located at the origin position. Then, the abnormality detecting unit sets the normal information in accordance with the design information corresponding to the design shape matched at that time. Consequently, the normal information can be made accurate and suitable for abnormality determination. Also, false determination due to the assembly errors can be prevented.

Moreover, it is preferred in the aspect of the present invention that the matching processing unit performs matching to the target component individually several times, and that the abnormality detecting unit detects an abnormality at each of the matching.

Several times of matching for each of the target components can detect an abnormality of a moving speed of the target component.

Moreover, it is preferred in the aspect of the present invention that a substrate treating system includes a plurality of substrate treating apparatus described above.

The substrate treating system provided with the plurality of substrate treating apparatus can also detect an abnormality based on the design information.

### BRIEF DESCRIPTION OF THE DRAWINGS

**For the purpose of illustrating the invention, there are shown in the drawings several forms which are presently preferred, it being understood, however, that the invention is not limited to the precise arrangement and instrumentalities shown.**
Fig. 1 is a side view of a substrate treating apparatus according to an embodiment.
Fig. 2 is a plan view of the substrate treating apparatus according to the embodiment.
Fig. 3 is a block diagram of the substrate treating apparatus according to the embodiment.
Fig. 4 is a schematic view for explanation of a concept of matching about three-dimensional design information.
Fig. 5 is an explanation view about input and output of a matching processing unit and an abnormality detecting unit.
Fig. 6 is a view for explanation of matching about a nozzle.
Fig. 7 is a flowchart illustrating a series of treatment of the substrate treating apparatus according to the embodiment.
Fig. 8 is an explanation view of a state where the nozzle is moved to an origin position.
Fig. 9 is an explanation view for detection of an abnormality of a chuck.
Fig. 10 is an explanation view for detection of an abnormality of the chuck.
Fig. 11 is an explanation view for detection of abnormalities of the nozzle and a guard.
Fig. 12 is a schematic view of a substrate treating system according to one embodiment.

### DESCRIPTION OF THE PREFERRED EMBODIMENTS

Preferred examples of this invention will be described in detail hereinafter with reference to the drawings.

### <1. Overall Configuration>

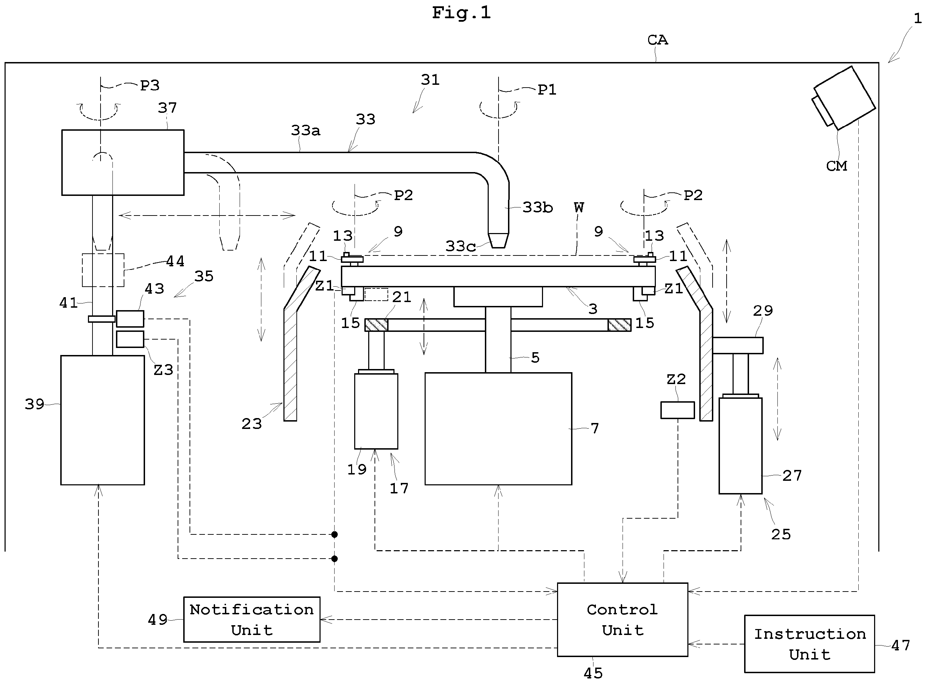

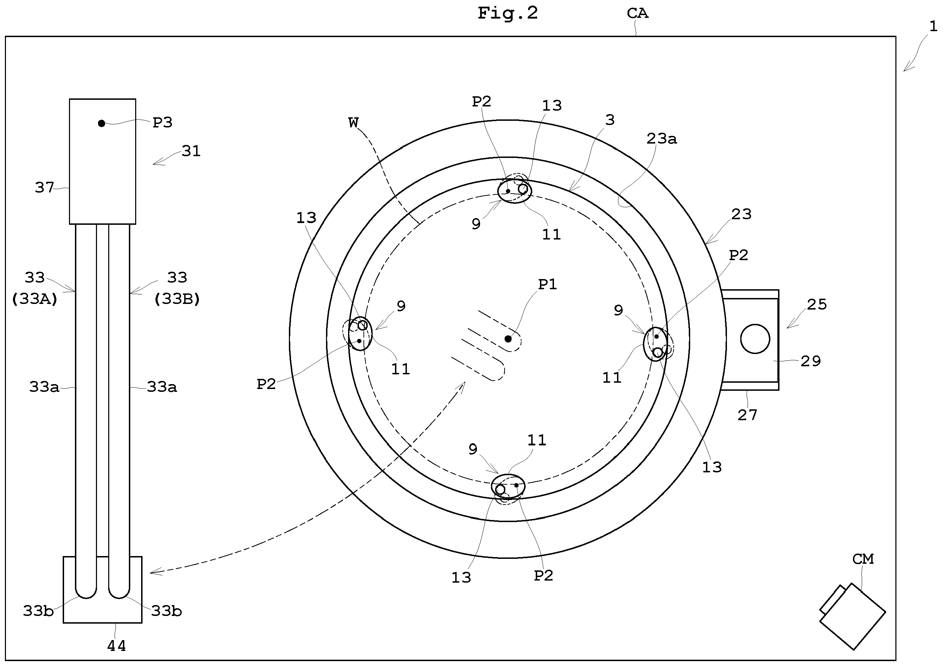

Fig. 1 is a side view of a substrate treating apparatus according to an embodiment. Fig. 2 is a plan view of the substrate treating apparatus according to the embodiment.

A substrate treating apparatus 1 is a single-wafer processing apparatus for treating substrates W one by one. The substrate W has a circular shape in plan view, for example. The substrate treating apparatus 1 performs predetermined treatment on the substrate W by supplying a treatment liquid while rotating the substrate W.

The substrate treating apparatus 1 includes a casing CA. The casing CA blocks the interior thereof from the surrounding atmosphere. The substrate treating apparatus 1 includes a spin chuck 3. The spin chuck 3 has a circular shape whose diameter is larger than a diameter of the substrate W in plan view. The spin chuck 3 includes a lower face connected to an upper end of a rotary shaft 5. A lower end of the rotary shaft 5 is connected to a motor 7. When the motor 7 is driven, the spin chuck 3 rotates around a rotation center The rotation center P1 extends in a vertical direction.

The spin chuck 3 includes a plurality of chucks 9. The spin chuck 3 includes the chucks 9 at a peripheral edge of an upper face thereof. In the present embodiment, the spin chuck 3 includes four chucks 9. The number of chucks 9 is not limited to four as long as the substrate W can rotate stably around the rotation center P1 while being supported in a horizontal posture.

The chucks 9 each include a back face supporting portion 11 and a periphery edge supporting portion 13. The back face supporting portion 11 contacts and supports a back face of the substrate W. It is preferred that the back face supporting portion 11 is formed so as to have a small contact area to the back face of the substrate W. This can reduce a degree of mutual contamination. The back face supporting portion 11 is attached to the upper face of the spin chuck 3 so as to rotate freely around a rotation center P2. The rotation center P2 extends in a vertical direction. The periphery edge supporting portion 13 is erected on an upper face of the back face supporting portion 11. It is preferred that the periphery edge supporting portion 13 is formed so as to have a height from the front face of the back face supporting portion 11 larger than a thickness of the substrate W. Such a construction can hold the periphery edge of the substrate W stably. The periphery edge supporting portion 13 is provided apart from the rotation center P2 toward an outer edge of the back face supporting portion 11 in plan view. In other words, the periphery edge supporting portion 13 is eccentric from the rotation center P2.

A rotating magnet 15 is attached to the lower face of the spin chuck 3 at a position corresponding to the rotation center P2. The rotating magnet 15 is connected to the back face supporting portion 11. The rotating magnet 15 is provided so as to rotate freely around the rotation center P2. A chuck drive mechanism 17 is located below the rotating magnet 15.

The chuck drive mechanism 17 is located more adjacent to the rotary shaft 5 than the chucks 9. The chuck drive mechanism 17 includes an air cylinder 19 and a driving magnet 21, for example. The driving magnet 21 has an annular shape in plan view. The air cylinder 19 is located in a posture where an operating shaft thereof is directed along the vertical direction. The driving magnet 21 is attached to a tip end of the operating shaft of the air cylinder 19. The chuck drive mechanism 17 is operated in response to a chuck operation command. When the chuck drive mechanism 17 is in an actuated state, the driving magnet 21 moves upward to approach the chucks 9. When the chuck drive mechanism 17 is in a non-actuated state, the driving magnet 21 moves downward to move apart from the chucks 9.

The chucks 9 each include a bias mechanism not shown. When the driving magnet 21 moves downward, the chuck 9 comes into a closed position. When the driving magnet 21 moves upward, the chuck 9 comes into an open position. In the closed position, the periphery edge supporting portion 13 rotates about the rotation center P2, and approaches toward the rotation center P1 to contact the periphery edge of the substrate W. This can cause the chucks 9 to grip the substrate W at the closed position. In the open position, the periphery edge supporting portion 13 rotates about the rotation center P2, and moves apart from the rotation center P1. This can cause the chucks 9 to load and unload the substrate W at the open position. Here, when the driving magnet 21 moves downward while the substrate W is not placed, the periphery edge supporting portion 13 is moved into an origin position shifted slightly inward from an outer diameter of the substrate W. In other words, the periphery edge supporting portion 13 is located more adjacent to the rotation center P1 at the origin position of the chucks 9 than at the closed position.

An origin sensor Z 1 is located adjacent to the rotating magnet 15 of the chuck 9. The origin sensor Z1 changes an output signal when the chuck 9 moves to the closed position or the origin position. For example, the origin sensor Z1 turns an output signal on when the chuck 9 moves to the closed position or the origin position.

A guard 23 is arranged around the spin chuck 3. The guard 23 surrounds the spin chuck 3 laterally. The guard 23 prevents scattering of a treatment liquid to the surrounding. The guard 23 has a tubular shape. An opening 23a of the guard 23 is formed at an upper part. An internal diameter of the opening 23a is larger than an outer contour of the spin chuck 3.

The guard 23 includes a guard moving mechanism 25. The guard moving mechanism 25 includes an air cylinder 27 and a locking piece 29, for example. The guard moving mechanism 25 is located adjacent to an outer periphery of the guard 23, for example. The guard moving mechanism 25 may be located adjacent to an inner periphery of the guard 23 as long as the guard 23 can move upward and downward. The air cylinder 27 is located in an attitude where an operating shaft thereof is directed toward the vertical direction. The locking piece 29 is attached to a tip end of the operating shaft of the air cylinder 27. The locking piece 29 is fixed to an outer peripheral face of the guard 23. The guard moving mechanism 25 is not limited to this construction as long as the guard 23 can move upward and downward.

The guard moving mechanism 25 moves the guard 23 between an origin position and a treating position in response to a guard operation command. The origin position is a position where an upper end of the guard 23 is low. The origin position is lower than the treating position. The treating position is higher than the origin position. An upper edge of the guard 23 is lower than the substrate W, supported by the spin chuck 3, in a state where the guard 23 is located at the origin position. The upper edge of the guard 23 is higher than the substrate W, supported by the spin chuck 3, in a state where the guard 23 is located at the treating position. For example, an origin sensor Z2 is located adjacent to the inner periphery of the guard 23. The origin sensor Z2 changes an output signal when the guard 23 moves to the origin position. For example, the origin sensor Z2 turns an output signal on when the guard 23 moves to the origin position.

The guard 23 includes a plurality of drain ports, not shown, adjacent to the inner periphery thereof. It is preferred that a plurality of guards 23 are provided such that the guard moving mechanism 25 moves the guards 23 upward and downward to perform switching of the drain ports. In this case, the drain ports are switched in accordance with the treatment liquid, and accordingly, the guard moving mechanism 25 changes levels of the guards 23.

A treatment liquid supplying mechanism 31 is located adjacent to the outer periphery of the guard 23. The treatment liquid supplying mechanism 31 includes a nozzle 33 and a nozzle moving mechanism 35, for example. In the present embodiment, the treatment liquid supplying mechanism 31 includes two nozzles 33, for example. In the following description, a nozzle on the left side in Fig. 2 is referred to as a nozzle 33A and a nozzle on the right side is referred to as a nozzle 33B appropriately if the two nozzles 33 need to be distinguished. The number of nozzles 33 of the treatment liquid supplying mechanism 31 may be one or three or more. In the present embodiment, the two nozzles 33 have the same construction.

The nozzle 33 includes an extension part 33a, a hang-down part 33b, and a distal end 33c. One end of the extension part 33a of the nozzle 33 is attached to a base part 37. The extension part 33a extends in a horizontal direction. The other end of the extension part 33a is connected to the hang-down part 33b. The hang-down part 33b extends downward along the vertical direction from the extension part 33a. The distal end 33c forms a lower end of the hang-down part 33b. The distal end 33c ejects a treatment liquid from a back face thereof. Examples of the treatment liquid include a photoresist, a spin-on glass (SOG) liquid, a developer, a rinse liquid, deionized water, and a cleaning liquid.

The nozzle moving mechanism 35 includes a motor 39, a rotary shaft 41, and a position detector 43, for example. The motor 39 is arranged in a vertical posture. The rotary shaft 41 is rotated around a rotation center P3 by the motor 39. The rotary shaft 41 is connected to the base part 37. The base part 37 is rotated by drive of the motor 39. The nozzle 33 swings around the rotation center P3 together with the base part 37. The position detector 43 detects a rotation position of the rotary shaft 41. The position detector 43 detects an angle of the rotary shaft 41 around the rotation center P3 in plan view. The position detector 43 outputs a pulse in accordance with the rotation position.

A standby cup 44 is located at a position apart laterally from the guard 23 in plan view. The standby cup 44 is located opposite to the base part 37 and adjacent to the distal end 33c of the nozzle 33 in plan view. The standby cup 44 is located at the origin position of the nozzle 33. The standby cup 44 prevents drying of the distal end 33c of the nozzle 33. The standby cup 44 is used for idle ejection of the nozzle 33. The nozzle moving mechanism 35 drives the motor 39 to swing the nozzle 33. The nozzle moving mechanism 35 moves the distal end 33c between the origin position and the ejecting position of the nozzle 33 above the rotation center P1 of the spin chuck 3.

For example, an origin sensor Z3 is located adjacent to an outer periphery of the rotary shaft 41. The origin sensor Z3 changes an output signal when the nozzle 33 is located at the origin position. For example, the origin sensor Z3 turns an output signal on when the nozzle 33 moves to the origin position. Here, the origin sensor Z3 is omittable for a simple construction. In this case, a projection is provided on a part of the rotary shaft 41 and a projection is provided on a fixed and immovable side of the substrate treating apparatus 1. The projections contact through rotation of the rotary shaft 41 and the position detector 43 detects a position where no more rotation is possible. The position is set as the origin position. Such configuration can be adopted. In this case, a position where a pulse of the position detector 43 is invariable may be set as the origin position.

A camera CM is attached to one area of the casing CA. For example, the camera CM is attached on a side where the standby cup 44 of the nozzle 33 is located at a corner adjacent to the guard moving mechanism 25 in plan view. Here, a position where the camera CM is located may be any location as long as a target component, described later, is within the field of view. A lens of the camera CM has a viewing angle at which the target component described later is entirely within the field of view. The lens of the camera CM has a viewing angle at which the origin position described later is entirely within the field of view.

The substrate treating apparatus 1 further includes a control unit 45, an instruction unit 47, and a notification unit 49. Details of the control unit 45 is to be described later. The instruction unit 47 is operated by an operator of the substrate treating apparatus 1. The instruction unit 47 is, for example, a keyboard or a touch panel. The instruction unit 47 instructs a target component, a timing to check, a tolerance, recipes, start of processing, and the like, which are to be described later. When the control unit 45 determines the presence of an abnormality, the notification unit 49 notifies the abnormality to the operator. Examples of the notification unit 49 include an indicator, a lamp, and a speaker.

### <2. Construction of Control System>

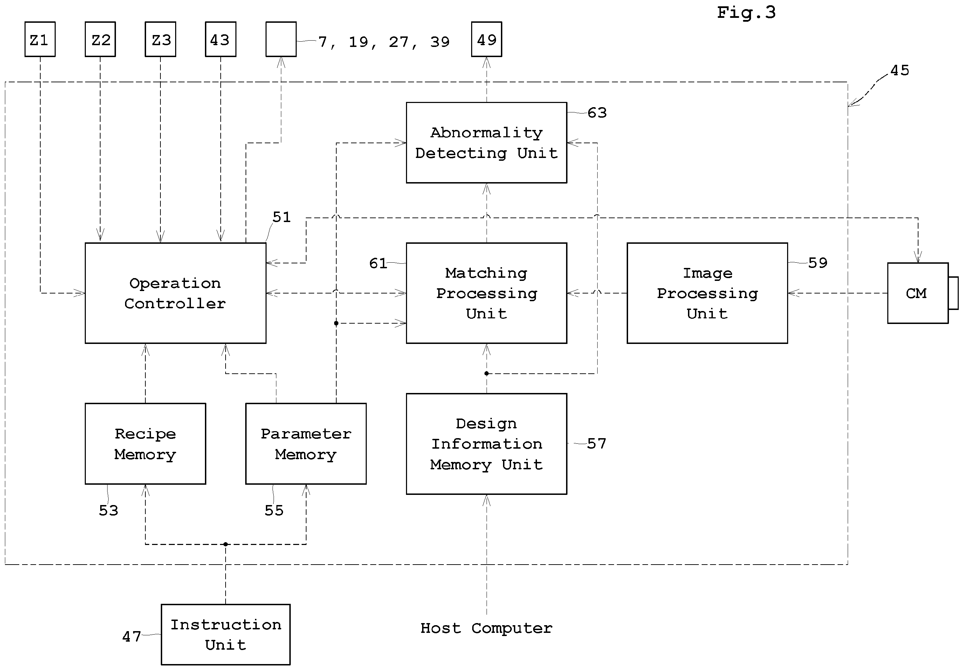

Reference is now made to Fig. 3. Fig. 3 is a block diagram of the substrate treating apparatus according to the embodiment.

The control unit 45 includes a CPU and a memory, for example. The control unit 45 is formed by a plurality of function blocks. Specifically, the control unit 45 includes an operation controller 51, a recipe memory 53, a parameter memory 55, a design information memory unit 57, an image processing unit 59, a matching processing unit 61, and an abnormality detecting unit 63.

The operation controller 51 operates the motors 7 and 39, the air cylinders 19 and 27, and the camera CM described above. The operation controller 51 receives signals from the origin sensors Z1 to Z3, and the position detector 43. The operation controller 51 operates in response to a recipe specified by the recipe memory 53. For example, the operator instructs a recipe and start of processing, and thereafter the operation controller 51 outputs various types of operation commands in accordance with the recipe to actuate the motor 7 and the like at a predetermined timing.

The recipe memory 53 stores various types of recipes in advance. The recipes define various procedures for treating the substrate W. The operator can operate the instruction unit 47 to instruct a desired recipe.

The parameter memory 55 stores a target component, a timing to check, a tolerance, and the like The target component is one of the components, forming the substrate treating apparatus 1, that is detected for abnormality. The timing to check is a timing for checking an operational status of the target component. An operation command outputted from the operation controller 51 may overlap a timing that movement of the target component is completed in response to the operation command at the timing to check. The operator may optionally operate the instruction unit 47 to set the target component, the timing to check, the tolerance and the like. The operator may cause the instruction unit 47 to instruct which component is set as the target component, which timing is set as the timing to check, to which degree a timing error or a positional error is acceptable as the tolerance.

The target component is, for example, the chuck 9, the guard 23, and the nozzle 33. The timing to check is, for example, as under: a timing where the chuck drive mechanism 17 operates to move the chuck 9 in response to the chuck operation command; a timing where the guard moving mechanism 25 operates to move the guard 23 upward and downward in response to a guard operation command ; a timing where the chucks 9 are set to be located at the closed position by the chuck operation command; a timing where the nozzle 33 is set to be located at the ejecting position by a nozzle operation command ; and a timing where the guard 23 is set to be located at the treating position by the guard operation command.

The tolerance indicates a degree of acceptance for a position where the target component should be if normal operation is performed at the timing to check. The tolerance indicates, for example, an acceptable degree of deviation from a position or an angle where the target component is intended by design. The tolerance indicates a range of the deviation of the target component at the timing to check that allows treatment to the substrate W even if the target component deviates from the position or the angle intended by design with respect to the treatment to the substrate W as a reference.

The operation controller 51 described above informs the matching processing unit 61 of positional information that the target component is located at the timing to check in accordance with the information from the position detector 43 and the parameter memory 55. The operation controller 51 informs the matching processing unit 61 of positional information that the target component is located at the origin position in accordance with the information from the origin sensors Z1 to Z3. The operation controller 51 informs the matching processing unit 61 of the positional information of the target component by operation to the air cylinders 19 and 27 and an electric motor 39. The operation controller 51 informs the matching processing unit 61 that an operation command has been outputted to each component in response to the recipes.

The design information memory unit 57 stores in advance design information of the components that form the substrate treating apparatus 1. Specifically, the information corresponds to design information about the components that form the substrate treating apparatus 1 and a substrate W to be treated. The design information is, for example, data of three-dimensional computer aided design (3D CAD). The design information may contain physical property information about the treatment liquid and various materials used for treatment.

3D CAD data is represented by three axes of orthogonal coordinate. When the components are arranged in a three-dimensional space, the 3D CAD data is represented by positional information about a position and an angle, for example. A host computer, not shown, stores three-dimensional design information as the 3D CAD data about all the components and materials of the substrate treating apparatus 1. The design information memory unit 57 stores in advance the design information about at least target components transferred from the host computer. It is preferred that the design information memory unit 57 stores information limited not to the design information of all the components of the substrate treating apparatus 1 but to the design information of the target component. This can save a storage capacity of the design information memory unit 57. Moreover, since the information is limited to the design information within the tolerance containing an original position where the target components should be in a normal operation at the timing to check, the storage capacity can particularly be saved when matching of the moving target component is determined.

The image processing unit 59 processes a real image captured by the camera CM. The image processing unit 59 performs an image processing to the real image, and extracts a real image shape containing a two-dimensional shape of the target component. The image processing unit 59 extracts the real image shape for all components in the real image by contour extraction, for example. Here, a contour contains not only an outer contour but also an edge part inside of the outer contour. The real image shape extracted by the image processing unit 59 is sent to the matching processing unit 61.

The matching processing unit 61 performs matching. Here, the matching corresponds to determination of which of the target components appears in the real image shape from the image processing unit 59. Specifically, the matching processing unit 61 determines which of the target components matches the real image shape in accordance with a degree of coincidence of feature points between the real image shape from the image processing unit 59 and a two-dimensional design shape based on the three-dimensional design information about the target component from the parameter memory 55. More specifically, the matching processing unit 61 performs matching between the real image shape from the image processing unit 59 and the design shape for each target component when at least the target component is brought into the timing to check. The matching by the matching processing unit 61 is to be described later in detail. The design shape corresponds to the two-dimensional shape information based on the three-dimensional design information at the timing to check. The two-dimensional shape information is a figure.

The matching processing unit 61 sometimes performs matching in response to a command from the operation controller 51 even when the timing to check does not come. For example, the operation controller 51 causes the matching processing unit 61 to perform matching in accordance with the output signals from the origin sensors Z1 to Z3. This matching (origin patching) is preferably performed only once when the substrate treating apparatus 1 actuates to start treatment to the substrate W. Moreover, the matching processing unit 61 may perform matching at any timing containing the timing to check. The matching processing unit 61 outputs information about the matched target component to the abnormality detecting unit 63.

The abnormality detecting unit 63 detects an abnormality of the target component when receiving the output from the matching processing unit 61. Specifically, the abnormality detecting unit 63 receives from the matching processing unit 61 information about the target component, reality information about the matched target component based on the real image and normal information based on the three-dimensional design information when the target component is normal. The abnormality detecting unit 63 compares the reality information with the normal information. From the results of the comparison, if no coincidence is found between the reality information and the normal information, the abnormality detecting unit 63 detects an abnormality. The normal information corresponds to positional information containing the position and the angle based on the three-dimensional design information. The normal information preferably contains the three-dimensional design information of the target component when the information of the target component falls within the tolerance. The reality information is based on the real image of the matched target component and corresponds to information representing a condition where the target component is really present at the timing to check. It is preferred that the normal information is an image based on the three-dimensional design information and the reality information is an image of the target component. This allows easy comparison between the reality information and the normal information.

The abnormality detecting unit 63 causes the notification unit 49 to perform notification operation in accordance with the detection results. Specifically, the abnormality detecting unit 63 causes the notification unit 49 to perform notification operation only when an abnormality is detected. The notification unit 49 may perform notification operation about the target component or the positional information detected as abnormal together with occurrence of the abnormality, for example.

### <3. Concept of matching>

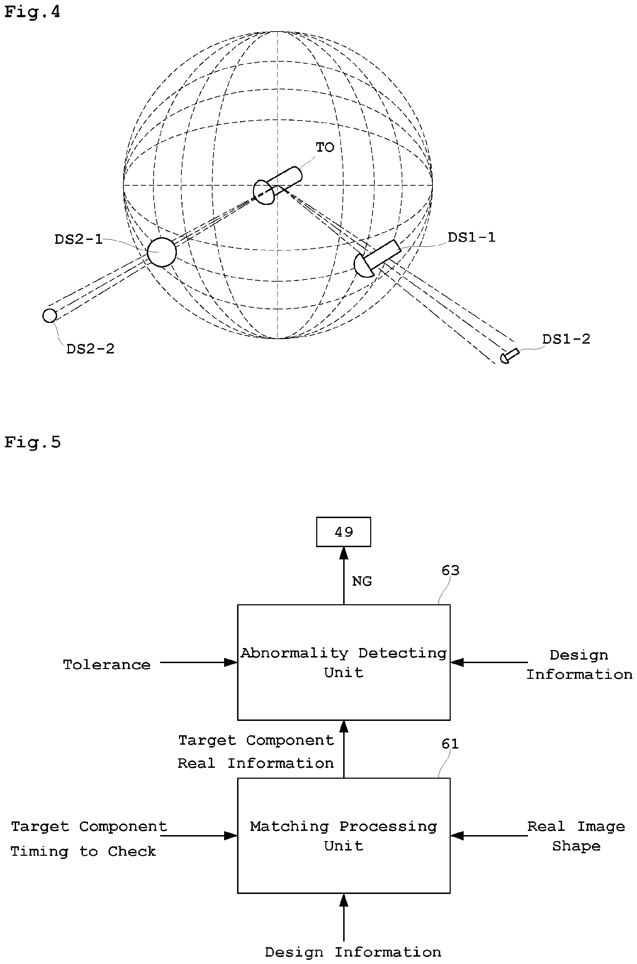

Reference is next made to Fig. 4. Fig. 4 is a schematic view for explanation of a concept of matching about the three-dimensional design information.

A rivet is represented as a target component TO in Fig. 4 for easy understanding. The two-dimensional design shape described above is a two-dimensional shape that is obtained when the target component TO placed at the center is seen from its entire circumference.

For example, a design shape seen from a close distance on the lower right side of the target component TO is designated as a design shape DS1-1, and a design shape seen from a far distance is designated as a design shape DS1-2 in Fig. 4. Otherwise, for example, a design shape seen from a close position on the lower left side of the target component TO is designated as a design shape DS2-1, and a design shape seen from a far distance is designated as a design shape DS2-2 in Fig. 4. As such, when the target component TO is seen from the lower right side, the design shape DS 1-1 has a shape of a rivet whose semi-circular head is positioned on the left side. The design shape DS1-2 is smaller than the design shape DS1-1. Moreover, when the target component TO is seen from the lower left side, the design shape DS2-1 has a shape of a rivet but only its head is visible. The design shape DS2-2 is smaller than the design shape DS2-1.

The matching processing unit 61 described above determines which of the target components TO matches the real image shape in accordance with a degree of coincidence of feature points between the real image shape based on a real image captured by the camera CM and the design shapes of all the target components TO at least at the timing to check. The abnormality detecting unit 63 detects an abnormality of the target component when receiving the results from the matching processing unit 61.

Reference is made to Fig. 5. Fig. 5 is an explanation view about input and output of the matching processing unit and the abnormality detecting unit.

In summary of the above, the matching processing unit 61 has an input-output relationship shown in Fig. 5. That is, the matching processing unit 61 obtains the real image shape from the image processing unit 59. The matching processing unit 61 receives the target components and the timing to check from the parameter memory 55. The matching processing unit 61 obtains the three-dimensional design information from the design information memory unit 57. The matching processing unit 61 outputs a target component to be matched and reality information to the abnormality detecting unit 63. The abnormality detecting unit 63 detects an abnormality of the matched target component in accordance with the result obtained through comparison between the reality information and the normal information with the tolerance added. The abnormality detecting unit 63 output a command NG to the notification unit 49 when an abnormality is detected.

### <4. Specific example of matching>

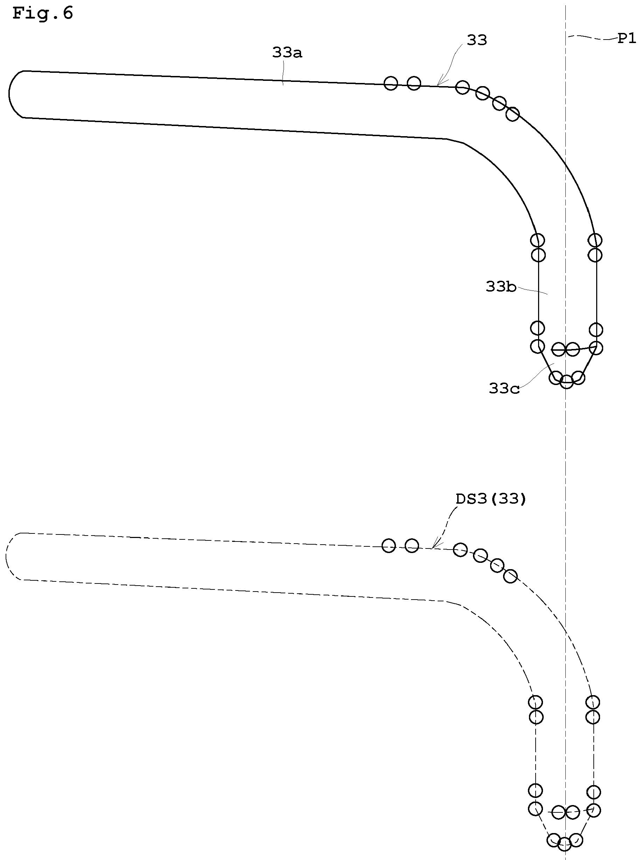

Reference is next made to Fig. 6. Fig. 6 is a view for explanation of matching about the nozzle.

Here, as one example, a timing that an operation command is received so that the distal end 33c of the nozzle 33 is positioned at the rotation center P1 (ejecting position) and movement of the nozzle is completed is defined as a timing to check. The nozzle 33 illustrated on the upper part of Fig. 6 corresponds to the real image shape. The nozzle 33 illustrated on the lower part of Fig. 6 corresponds to a two-dimensional design shape DS of the three-dimensional design information about the nozzle 33 when the nozzle 33 is seen from any point of the entire periphery as shown in Fig. 4.

In this case, for example, a degree of coincidence of the feature points between the real image shape and the design shape DS is examined at all of the feature points indicated by small circles. Such processing is to be performed to other two-dimensional design shapes DS when seen at the entire periphery and various distances. In this case, all the feature points in the real image shape and the design shape DS in Fig. 6 are coincidence. Consequently, the degree of coincidence is equal to or more than a predetermined value. Then, the matching processing unit 61 determines that the matching is made. In other words, it is determined that the real image shape includes the nozzle 33 as the target component. Here in this example, description is only made to the nozzle 33, but it is determined whether other target components are present in the real image shape. If the matching result of the degree of coincidence is less than the given value, it is determined that no matching is made.

### <5. Specific example of treatment>

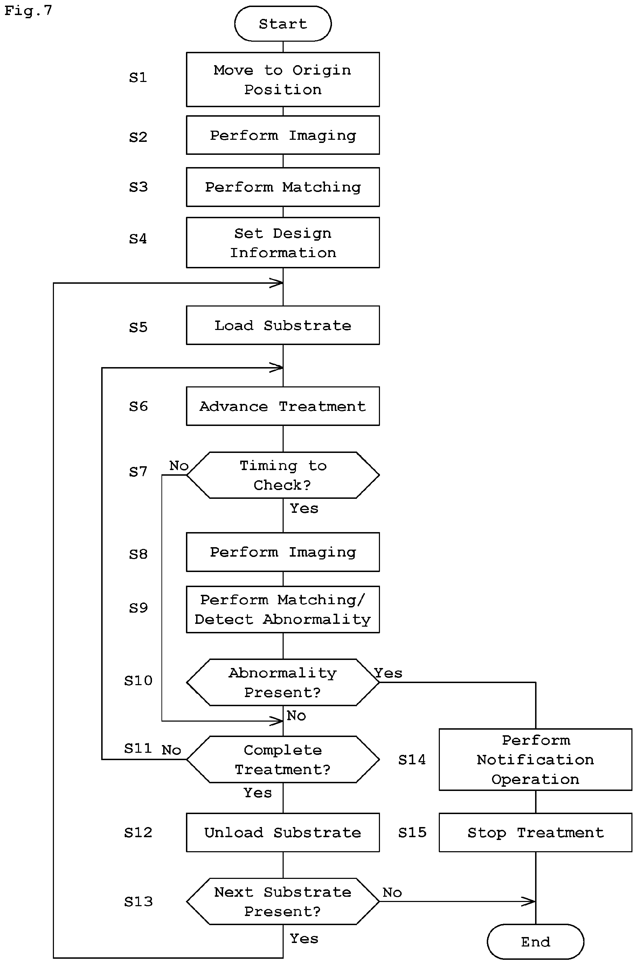

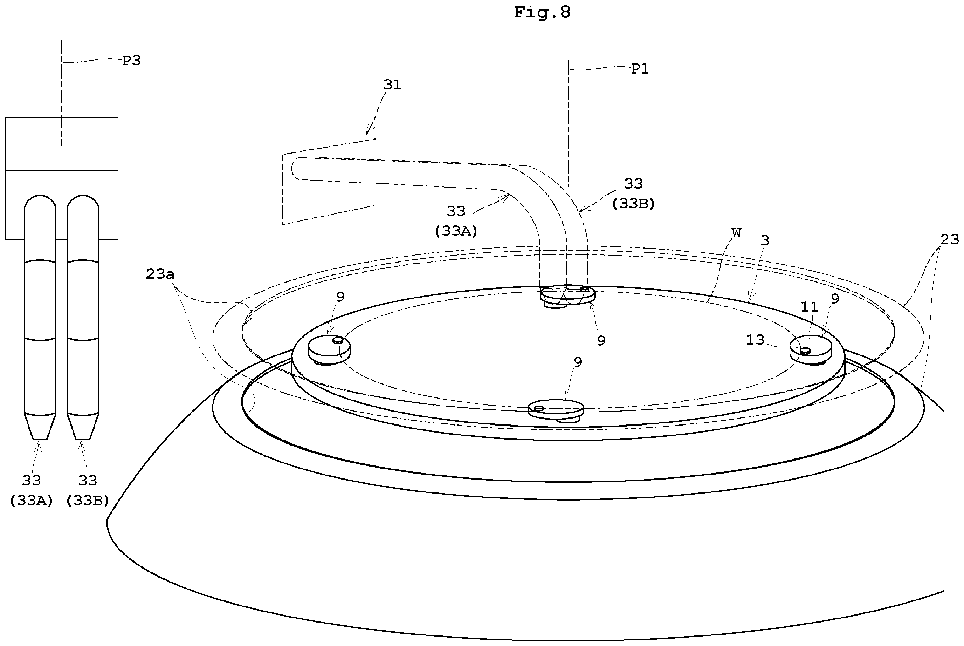

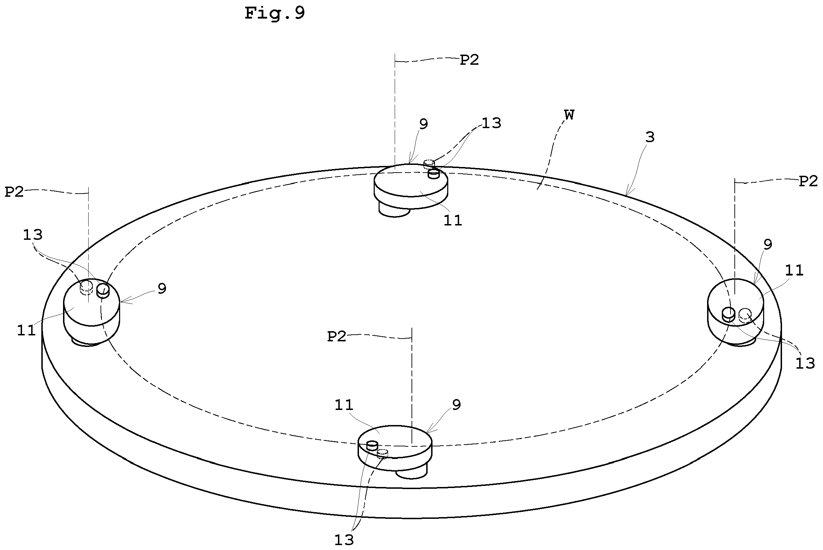

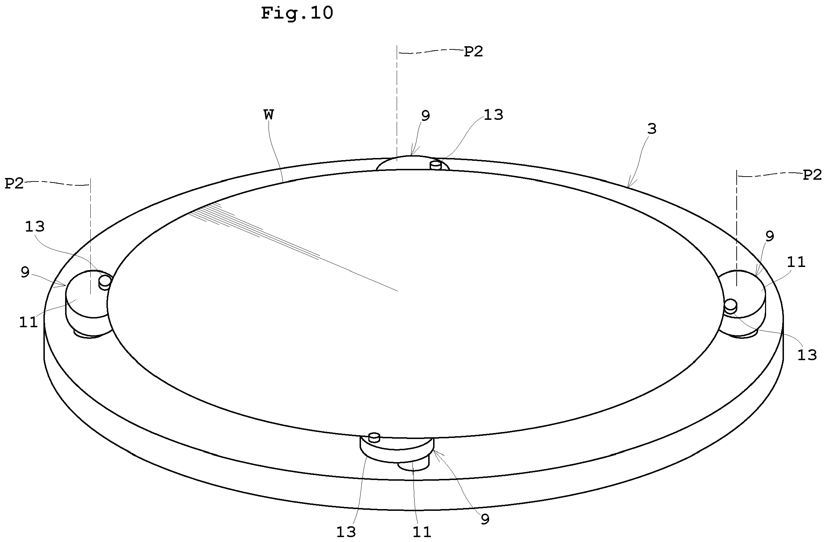

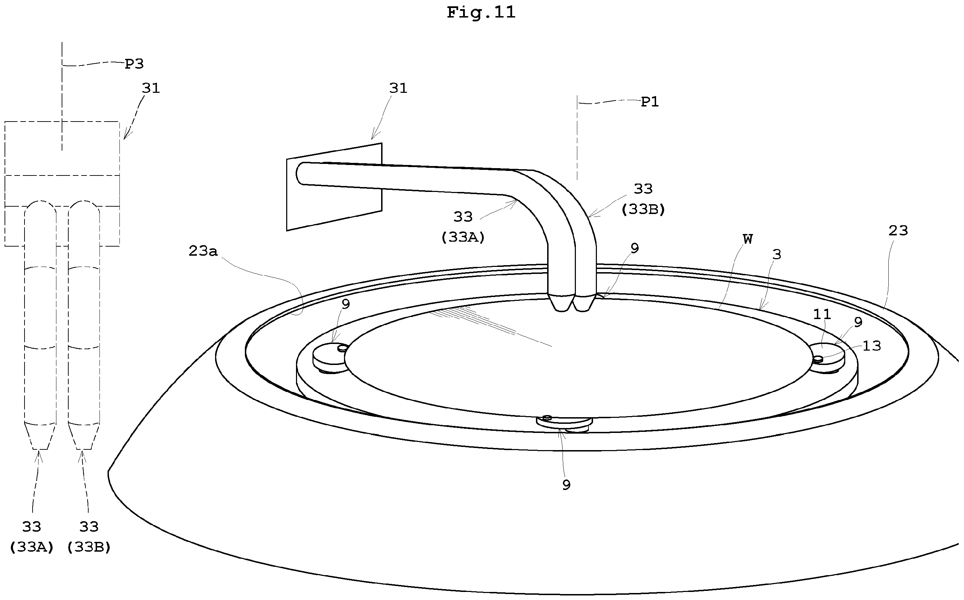

Next, description will be given of a specific example of treatment with reference to Figs. 7 to 11. Fig. 7 is a flowchart illustrating a series of treatment of the substrate treating apparatus according to the embodiment. Fig. 8 is an explanation view of a state where the nozzle is moved to the origin position. Figs. 9 and 10 are each an explanation view for detection of an abnormality of the chuck. Fig. 11 is an explanation view for detection of abnormalities of the nozzle and the guard.

An operator previously operates the instruction unit 47 to instruct a recipe in the recipe memory 53. The operation controller 51 operates each component in response to the instructed recipe to advance the treatment to the substrate W.

### Step S1

Movement to the origin position is performed. Specifically, the operation controller 51 operates the chuck drive mechanism 17, the guard moving mechanism 25, and the nozzle moving mechanism 35. The operation controller 51 operates the chuck drive mechanism 17 by a chuck operation command to move the chucks 9 to the origin position. At this time, an output signal from the origin sensor Z1 turns on. The operation controller 51 determines that the chucks 9 are moved to the origin position from the output signal from the origin sensor Z1. The operation controller 51 operates the guard moving mechanism 25 by a guard operation command to move the guard 23 to the origin position.

As illustrated in Fig. 8, the nozzle 33 is rotated about the rotation center P3, whereby the distal end 33c thereof is moved to the origin position laterally apart from the guard 23. The guard 23 is moved to an origin position where an opening 23a thereof is lower than the substrate W. This is illustrated in Fig. 8 by solid lines. Here, chain double-dashed lines in Fig. 8 illustrates a treating position where the opening 23a is higher than the substrate W.

As illustrated in Fig. 9, the chuck 9 is rotated around the rotation center P2 in response to the chuck operation command while the substrate W is not placed thereon, whereby a periphery edge supporting portion 13 is moved toward the rotation center P1 of the spin chuck 3. This is illustrated in Fig. 9 by solid lines. Accordingly, the periphery edge supporting portion 13 of each of the chucks 9 is moved to a position where the periphery edge supporting portion 13 contacts a circle whose diameter is slightly smaller than the outer diameter of the substrate W.

### Step S2

Imaging is performed. Specifically, the operation controller 51 performs imaging by the camera CM using a timing where the nozzle 33, the chucks 9, and the guard 23 move to the origin position as a trigger. Specifically, the operation controller 51 performs imaging of the nozzle 33, the chucks 9, and the guard 23 such that at least the feature points are imaged. The image processing unit 59 performs an image processing to the real image captured by the camera CM, and extracts a real image shape containing the two-dimensional shapes of the nozzle 33, the chucks 9, and the guard 23.

### Steps S3 and S4

The matching processing unit 61 performs matching. The following describes the detailed processing.

### <Origin position: nozzle 33>

The matching processing unit 61 performs matching between the real image shape of the nozzle 33 extracted by the image processing unit 59 and the design shape of the nozzle 33. The matching processing unit 61 sets the normal information at the timing to check in the case where the nozzle 33 is located except for the origin position in accordance with the three-dimensional design information corresponding to the matched design shape of the nozzle 33.

Specifically, the design information corresponding to the matched design shape at the origin position of the nozzle moving mechanism 35 is linked to the origin position. Then, the normal information is set in accordance with the design information at the ejecting position of the nozzle 33 by design in response to a number of pulses from the origin position to the ejecting position. Consequently, the normal information of the nozzle 33 can be made accurate and suitable for abnormality determination. Also, false determination of the nozzle 33 and the nozzle moving mechanism 35 due to assembly errors can be prevented.

### <Origin position: chuck 9>

The matching processing unit 61 performs matching between the real image shape of the chucks 9 extracted by the image processing unit 59 and the design shape of the chucks 9. The matching processing unit 61 sets the normal information at the timing to check in the case where the chucks 9 are located except for the origin position in accordance with the three-dimensional design information corresponding to the matched design shape of the chuck 9.

Specifically, the normal information is set in accordance with the design information corresponding to the design shape matched at the origin position of the chucks 9. The chuck 9 is an important component for gripping the substrate W. A gripping state of the chuck 9 is adjusted for every substrate treating apparatus 1, and thus the origin position may sometimes be slightly different in design. Accordingly, the normal information is set with reference to the origin position, false determination caused by adjustment of the gripping state can be prevented.

### <Origin position: guard 23>

The matching processing unit 61 performs matching between the real image shape of the guard 23 extracted by the image processing unit 59 and the design shape of the guard 23. The matching processing unit 61 sets the normal information at the timing to check in the case where the guard 23 is located except for the origin position in accordance with the three-dimensional design information corresponding to the matched design shape of the guard 23.

Note that the processing may be shifted to step S14, which is to be described later, to perform notification of an abnormality when no matching is obtained or the three-dimensional design information corresponding to the matched design shape largely deviates from the origin position in design in the step S3 described above.

### Step S5

The substrate W to be treated is loaded into the substrate treating apparatus 1.

### Step S6

Treatment to the substrate W proceeds along a recipe. Specifically, the substrate W is firstly placed on the chucks 9. The operation controller 51 operates the chuck drive mechanism 17 by a chuck operation command to move the chucks 9 to the closed position, for example. Such a state is, for example, like one illustrated in Fig. 10. That is, the chuck 9 is rotated around the rotation center P2 while the substrate W is placed thereon, whereby a periphery edge supporting portion 13 is moved toward the rotation center P1 of the spin chuck 3. Accordingly, the periphery edge supporting portion 13 of each of the chucks 9 contacts the outer diameter of the substrate W, thereby gripping the substrate W. The periphery edge supporting portion 13 at this time is located slightly closer to the outer periphery than the periphery edge supporting portion 13 in Fig. 9 in plan view.

### Step S7

It is determined whether it is the timing to check or not. Specifically, the operation controller 51 refers to the target component and its timing to check stored in the parameter memory 55. The processing is branched in accordance with whether the target component is at the timing to check or not. If it is not at the timing to check, the procedure is shifted to a step S11. At this time, the procedure is shifted to a step S8 under assumption that the target component is at the timing to check.

### Step S8

Since it is a timing to check where the chucks 9 are set to be located at the closed position , the operation controller 51 causes the camera CM to perform imaging. Specifically, the camera CM is operated in accordance with a timing where the chucks 9 are moved to the closed position by a chuck operation command. The camera CM captures a real image of components containing the chuck 9. Accordingly, the image processing unit 59 extracts a real image shape as a two-dimensional shape of the target component. As illustrated in Fig. 10, a chuck 9 of four chucks 9 that is apart from the camera CM does not appear as a whole image in a shape of the real image. That is, only the outside from the outer periphery of the substrate W appears in the shape of the real image. However, since the periphery edge supporting portion 13 of the chuck 9 appears, matching can be performed successfully by verifying the feature point thereof.

### Step S9

The matching processing unit 61 performs matching. Specifically, the matching processing unit 61 verifies the degree of coincidence of the feature points for the real image shape and the design shape of each chuck 9. The matching processing unit 61 determines whether the matching is made or not in such a manner as in the example described with reference to Fig. 6. Moreover, the abnormality detecting unit 63 performs abnormality detection. Specifically, the abnormality detecting unit 63 compares the reality information with the normal information about the matched chuck 9. If there is no coincidence through the result of the comparison, the abnormality detecting unit 63 detects an abnormality.

### Step S10

The processing is branched in accordance with the detection result from the abnormality detecting unit 63. Specifically, if the chuck 9 is normal, the processing is shifted to a step S11. In contrast to this, if the chuck 9 is abnormal, the processing is branched to a step S14.

Here, description is made under an assumption that the chuck 9 is normal.

### Step S11

The processing is branched in accordance with whether the processing is completed or not. If the processing is completed, the processing is branched to a step S12. If the processing is not completed, the processing returns to the step S6. At this point, the processing is not completed since the substrate W is merely placed on and gripped by the chucks 9. Consequently, the processing returns to the step S6.

### Step S6

The operation controller 51 operates the guard moving mechanism 25 by a guard operation command, and moves the guard 23, located at the origin position as in Fig. 8, to the treating position as in Fig. 11, for example. Here, the nozzle 33 located above the substrate W in Fig. 11 is located at the origin position at this time.

### Step S7

It is determined whether it is the timing to check or not. Specifically, the operation controller 51 refers to the target component and its timing to check stored in the parameter memory 55. The operation controller 51 branches the processing in accordance with whether the target component is at the timing to check or not. At this time, since the guard 23 is the target component and at the timing to check, the processing is shifted to a step S8.

### Step S8

Since it is a timing to check where the guard 23 is set to be located at the treating position , the operation controller 51 causes the camera CM to perform imaging. Thereby, the camera CM captures the real image of components containing the guard 23. Accordingly, the image processing unit 59 extracts a real image shape, as a two-dimensional shape, containing the guard 23 from the real image.

### Step S9

The matching processing unit 61 performs matching. Specifically, the matching processing unit 61 firstly reads out the design information of the guard 23 from the design information memory unit 57. The matching processing unit 61 verifies the degree of coincidence of the feature points for the real image shape and the two-dimensional design shape based on the design information. The matching processing unit 61 determines whether the matching is made or not in such a manner as in the example described with reference to Fig. 6. The abnormality detecting unit 63 compares the reality information with the normal information about the matched guard 23.

### Step S10

The processing is branched in accordance with the result of the abnormality detecting unit 63. Specifically, if the guard 23 is normal, the processing is shifted to a step S11. In contrast to this, if the guard 23 is abnormal, the processing is branched to a step S14.

Here, description is made under an assumption that the guard 23 is normal.

### Step S11

Here, it is merely that the substrate W is gripped by the chucks 9 and the guard 23 is moved to the treating position. Since the processing is not completed, the processing returns to the step S6.

### Step S6

The operation controller 51 starts to move the nozzle 33 in accordance with a recipe. For example, the operation controller 51 operates the nozzle moving mechanism 35 by a nozzle operation command, and moves the nozzle 33B of the two nozzles 33A and 33B from the origin position to the ejecting position as in Fig. 11. The ejecting position is, for example, a position equal to the rotation center P1.

### Step S7

The operation controller 51 refers to the timing to check of the parameter memory 55. The operation controller 51 branches the processing in accordance with whether the target component is at the timing to check or not. At this time, since the nozzle 33 (nozzle 33B) is at the timing to check, the processing is shifted to the step S8.

### Step S8

Since it is a timing to check where the nozzle 33B is set to be located at the ejecting position , the operation controller 51 causes the camera CM to perform imaging. Thereby, the camera CM captures the real image of components containing the nozzle 33B. Accordingly, the image processing unit 59 extracts a real image shape, as a two-dimensional shape, containing the nozzle 33B from the real image.

### Step S9

The matching processing unit 61 performs matching. Specifically, the matching processing unit 61 firstly reads out the design information of the nozzle 33B from the design information memory unit 57. The matching processing unit 61 verifies the degree of coincidence of the feature points for the real image shape and the two-dimensional design shape based on the design information. The matching processing unit 61 determines whether the matching is made or not in such a manner as in the example described with reference to Fig. 6. As illustrated in Fig. 11, the nozzle 33B is arranged on a rear face side of the nozzle 33A. Accordingly, the entire of the nozzle 33B does not appear in the real image shape. However, since a characteristic shape of the nozzle 33B is visible, there is no problem in performing the matching. The abnormality detecting unit 63 compares the reality information with the normal information about the matched nozzle 33B. If there is no matching through the comparison, the processing is shifted to the step S14 or otherwise the processing is shifted to the step S10.

### Step S10

The processing is branched in accordance with the result of the abnormality detecting unit 63. Specifically, if the nozzle 33B is normal, the processing is shifted to a step S11. In contrast to this, if the nozzle 33B is abnormal, the processing is branched to a step S14.

Here, description is made under an assumption that the nozzle 33B is normal.

### Step S11

The processing is not completed since the nozzle 33B is merely moved to the ejecting position. Consequently, the processing returns to the step S6.

### Steps S6, S7, and S11

The operation controller 51 advances the processing by rotating the motor 7, for example, in accordance with the recipe. Thereafter, the steps S6, S7 and S11 are repeated. Consequently, it is determined that the nozzle 33B supplies the treatment liquid to the substrate W, for example, and treatment to the substrate W is completed. The processing is shifted to step S12 when the processing in accordance with the recipe is completed.

### Step S12

The operation controller 51 causes the nozzle 33B, the guard 23, and the chucks 9 to return to the origin position. The operation controller 51 unloads the substrate W, placed on the spin chuck 3, to the outside.

### Step S13

The operation controller 51 branches the processing in accordance with whether a next substrate W is present or not. That is, if a next substrate W is present, the processing is shifted to the step S5. Then, the next substrate W is loaded, and the substrate W is treated in such a manner as described above. Note that matching is not performed at the origin position when the next substrate W is treated. If a next substrate W is not present, the processing is completed.

The following describes a case where the target component is determined abnormal in the step S10.

### Step S14

When the abnormality detecting unit 63 detects an abnormality, the abnormality detecting unit 63 causes the notification unit 49 to perform notification operation. The notification unit 49 may perform notification operation about the target component to be detected as abnormal, the positional information, or the contexts of the abnormality collectively, for example.

Specifically, as for the nozzle 33, an abnormality about operation of the nozzle moving mechanism 35, an abnormality caused by deformation of the outer contour and the like are notified. As for the chucks 9, an abnormality about the operation of the chuck drive mechanism 17, an abnormality caused by damages of the back face supporting portion 11 or the periphery edge supporting portion 13 of the chuck 9 and the like are notified. As for the guard 23, an abnormality about operation of the guard moving mechanism 25, an abnormality caused by deformation of an outer contour of the opening 23a of the guard 23 and the like are notified.

### Step S15

The operator receives notification from the notification unit 49, and stops operation of the substrate treating apparatus 1, for example. This stops the treatment to the substrate W, thereby preventing continuous processing under an abnormal condition. This can prevent poor treatment to the substrate W in advance.

With the present embodiment, the matching processing unit 61 determines which of the target components matches the real image in accordance with the degree of coincidence of feature points between the real image shape and the design shape. The matching processing unit 61 performs matching in accordance with the degree of coincidence of the feature points. Accordingly, the matching can be performed while minimizing an environment difference upon imaging and an influence of a light source, water droplets, or fumes. The abnormality detecting unit 63 detects the abnormality of the target component, matched in the matching processing unit 61, through comparison between reality information about the matched target component based on the real image and normal information based on the three-dimensional design information when the target component is normal. Consequently, matching accuracy is enhanced, and thus the abnormality detecting unit 63 can detect an abnormality of the component accurately. Moreover, even if part of the target component is not visible during imaging, matching can be performed as long as the feature point appears in the real image shape. This can minimize an influence of the positional relationship between the target component and other components.

Here, a correspondence between the above steps and the present invention is as under. The steps S2 and S8 correspond to the "imaging step" in the present invention. The steps S3 and S9 correspond to the "matching step" in the present invention. The step S9 corresponds to the "abnormality detecting step" in the present invention. The camera CM corresponds to the "imaging unit" in the present invention. The position detector 43 corresponds to the "nozzle pulse output unit" in the present invention. The operation controller 51 corresponds to the "nozzle movement control unit" in the present invention.

### <6. Substrate treating system>

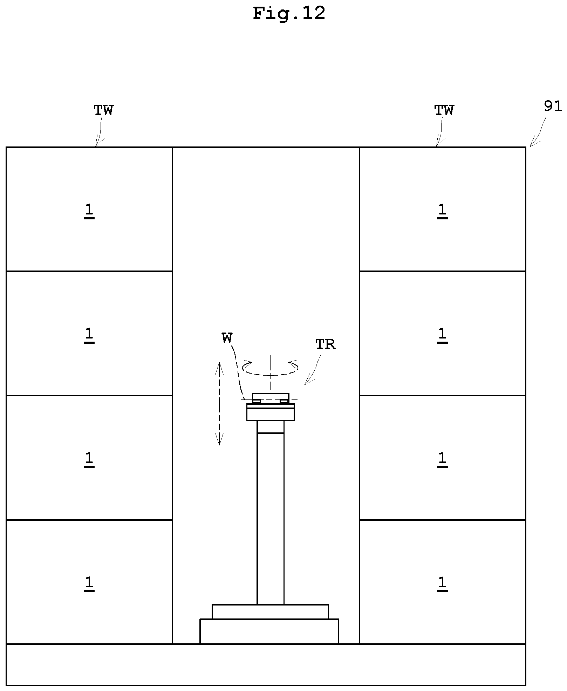

While the embodiment described above is a single configuration of the substrate treating apparatus 1, the present invention can also be applied to the following construction. Reference is now made to Fig. 12. Fig. 12 is a schematic view of a substrate treating system according to one embodiment.

A substrate treating system 91 includes the substrate treating apparatus 1 described above arranged in a stack manner. The substrate treating system 91 includes towers TW in which four stages of the substrate treating apparatus 1 are arranged in a height direction, for example. In the substrate treating system 91, the towers TW are arranged so as to face apart from each other. In the substrate treating system 91, transport robot TR is arranged between the towers TW. The transport robot TR is configured so as to move upward and downward freely in the height direction. The transport robot TR is configured so as to advance and withdraw an arm, not shown, to and from the substrate treating apparatus 1 freely. The transport robot TR delivers a substrate W among the substrate treating apparatus 1. The substrate treating system 91 having such a configuration as above can produce the effect in each of the substrate treating apparatus 1 as described above.

The substrate treating system 91 may include a camera that keeps the transport robot TR in the field of view, for example. Then, it is preferred that matching is set to be performed as described above at an origin position of the transport robot TR and at a timing to check that is set to be as a deliver position, and an arm, not shown, on which a substrate W is placed is set as a target component. This can detect an abnormality about deformation of the arm, an abnormality in the moving speed, and an abnormality of a drive system of the transport robot TR.

The present invention is not limited to the foregoing examples, but may be modified as follows.

(1) In the embodiment described above, the normal information is set in accordance with the three-dimensional design information within the tolerance. However, the present invention is not limitative to this. Specifically, the abnormality detecting unit 63 may set the normal information based on one type of the three-dimensional design information that the target component is normal. This can suppress a load of the abnormality detecting unit 63.
(2) In the embodiment described above, the chuck 9, the guard 23, and the nozzle 33 are described as one example of the target component. However, the present invention is not limited to this construction. For example, the spin chuck 3 may be used as the target component to detect an abnormality caused by deformation of the outer contour thereof. The substrate W to be processed may be set as the target component, and a timing set such that the chucks 9 are located in the closed position may be set as the timing to check. This can detect a damage of the substrate W as an abnormality. Moreover, a plurality of target components as in the embodiment or a target component may be provided. Moreover, the matching is not necessarily performed at the origin position.
(3) In the embodiment described above, the matching of the target component is performed only once at the timing to check other than the origin position. However, the present invention is not limitative to this. For example, the matching of the nozzle 33 may be set at a plurality of timings to check between the origin position and a position at a timing set such that the nozzle 33 is located at the ejecting position. Accordingly, when an abnormality is detected at a plurality of timings to check set such that the nozzle 33 is located between the origin position and the ejecting position, an abnormality in moving speed of the nozzle 33 by the nozzle moving mechanism 35 can also be detected, for example. Moreover, a plurality of timings to check of the guard 23 is set between the origin position and the treating position. In this case, an abnormality about the moving speed of the guard 23 by the guard moving mechanism 25 can be detected. Moreover, in the embodiment described above, the matching and the abnormality detection are performed using the timing to check as a trigger. However, the timing to check is not essential in the present invention. For example, matching and abnormality detection may be performed at every timing where the target component is moved in response to an issued command, such as a chuck operation command, to operate the target component.
(4) In the embodiment described above, the matching processing unit 61 performs matching between the real image shape and the design shape. However, instead of just the two-dimensional shape based on the three-dimensional design information, reflection and shading caused by a surface shape of each target component, reflection and shadows caused by a positional relationship in the casing CA and the environment may be reflected in the design shape, for example. As a result, common feature points with the real image shape can be increased, leading to prevention of misjudgment caused by the shape, environment, and the like.
(5) In the embodiment described above, the substrate treating apparatus 1 includes one camera CM. However, the present invention does not exclude provision of a plurality of cameras CM. For example, a plurality of cameras CM like a camera CM dedicated to the nozzle 33 and a camera CM dedicated to the chuck 9 may be provided. This can improve a detection accuracy of abnormalities, especially in the case of a small target component like the chuck 9, for example.
(6) In the embodiment described above, the matching at the origin position is performed. The following interference check may be performed using this as a reference. Specifically, if a shift in operation timing or deformation of an outer contour occurs when each target component moves, they may collide with each other. Then, the origin position may be used as a reference to check in advance whether interference occurs during or after movement of the target components in accordance with the design information. This can prevent interference that cannot be detected only by a sensor for detecting locations and the like.
(7) In addition to the construction of the embodiment described above, the target components may be the nozzle 33 and the treatment liquid, and abnormal supply of the treatment liquid, including time of ejecting the treatment liquid as the timing to check, may be detected. For example, with use of a fluid simulator, a trace line of the treatment liquid during normal supply is used as design information, matching is performed between a design shape based on the design information about the trace line of the treatment liquid and a real image shape of the ejected treatment liquid captured by the camera CM to compare the reality information and the normal information. This can also detect an abnormality of an ejection system for the treatment liquid. Moreover, a trace line of the treatment liquid when the treatment liquid is ejected logically and correctly may be simulated from a specified value of a flow control valve when the treatment liquid is supplied, and matching may be performed using the information of the trace line as the design information.
(8) In addition to the construction of the embodiment described above, a construction of a machine vision may be added. Specifically, when the target component is the nozzle 33, the position detector 43 calculates a position of the target component. Since it is understood which position the position corresponds in the real image shape, comparison is made between positional information of the target component in the real image captured at a given interval and the positional information of the position detector 43. If there is a difference between them, it is determined that an abnormality is present. At this time, the matching described above is used to find the target component in the real image shape. This can prevent error detection caused by reflection or shadows of the real image, droplets, fumes and the like.
(9) In the embodiment described above, the substrate treating apparatus 1 has been described as one example that performs treatment to the substrate W with the treatment liquid. However, the present invention is not limitative to such a construction of the substrate treating apparatus. For example, the present invention is also applicable to a device for heat-treating the substrate W, a device for transporting the substrate W, or a device for exposing the substrate W. Moreover, the present invention is not limited to a single-wafer processing apparatus for treating substrates W one by one as described in the above embodiment. In other words, the present invention is also applicable to a batch-type device for treating a plurality of substrates simultaneously.

The invention is defined by the appended claims.

## Claims

1. A substrate treating apparatus (1) for performing a predetermined treatment on a substrate, the apparatus comprising:
a design information memory unit (57) configured to store three-dimensional design information about at least target components to be detected for an abnormality;
an imaging unit (59) configured to capture a real image including the target components;
a matching processing unit (61) configured to determine which of the target components matches a real image shape as a two-dimensional shape in the real image captured by the imaging unit in accordance with a degree of coincidence of feature points between the real image shape and a two-dimensional design shape based on three-dimensional design information about the target components; and
an abnormality detecting unit (63) configured to detect an abnormality of a target component, matched in the matching processing unit, through comparison between reality information about the matched target component based on the real image and normal information based on three-dimensional design information when the matched target component is normal.

2. The substrate treating apparatus according to claim 1, wherein
the abnormality detecting unit (63) is configured to set the normal information based on three-dimensional design information of the target component when the target component is located within a tolerance where the target component is acceptable as normal.

3. The substrate treating apparatus according to claim 1, further comprising:
a spin chuck (3) configured to support the substrate in a horizontal posture and rotate the substrate;
a nozzle (33) configured to eject a treatment liquid from its distal end to the substrate supported by the spin chuck; and
a nozzle moving mechanism (35) configured to move the distal end of the nozzle between an origin position laterally apart from the substrate and an ejecting position above the substrate, wherein
the target component is the nozzle, and
the matching processing unit performs the matching at a timing set so as for the nozzle to be located at the ejecting position.

4. The substrate treating apparatus according to claim 2, further comprising:
a spin chuck (3) configured to support the substrate in a horizontal posture and rotate the substrate;
a nozzle (33) configured to eject a treatment liquid from its distal end to the substrate supported by the spin chuck; and
a nozzle moving mechanism (35) configured to move the distal end of the nozzle between an origin position laterally apart from the substrate and an ejecting position above the substrate, wherein
the target component is the nozzle, and
the matching processing unit is configured to perform the matching at a timing set so as for the nozzle to be located at the ejecting position.

5. The substrate treating apparatus according to claim 3, further comprising:
a nozzle pulse output unit (43) configured to output a pulse when the nozzle is moved from the origin position to the ejecting position; and
a nozzle movement control unit (51) configured to control the nozzle moving mechanism in accordance with the pulse from the nozzle pulse output unit, wherein
the nozzle movement control unit is configured to cause the matching processing unit to perform the matching only once at such a timing that the nozzle moving mechanism sets the distal end of the nozzle to be located at the origin position, and performs correlation of the design information corresponding to the design shape matched at the time with the pulse at the origin position, and
the abnormality detecting unit is configured to set the normal information in accordance with the correlation and the pulse at the ejecting position.

6. The substrate treating apparatus according to claim 4, further comprising:
a nozzle pulse output unit (43) configured to output a pulse when the nozzle is moved from the origin position to the ejecting position; and
a nozzle movement control unit (51) configured to control the nozzle moving mechanism in accordance with the pulse from the nozzle pulse output unit, wherein
the nozzle movement control unit is configured to cause the matching processing unit to perform the matching only once at such a timing that the nozzle moving mechanism sets the distal end of the nozzle to be located at the origin position, and performs correlation of the design information corresponding to the design shape matched at the time with the pulse at the origin position, and
the abnormality detecting unit is configured to set the normal information in accordance with the correlation and the pulse at the ejecting position.

7. The substrate treating apparatus according to claim 3, wherein
the spin chuck : (3) includes at its peripheral edge a plurality of chucks (9) each having a back face supporting portion for supporting a back face of the substrate and a periphery edge supporting portion erected outside of a rotation center of the back face supporting portion for supporting a periphery edge of the substrate,
the spin chuck (3) further includes a chuck drive mechanism (17) configured to rotate the plurality of chucks in response to a chuck operation command so as for the periphery edge supporting portion not to contact the periphery edge of the substrate at an open position where the substrate is loaded and unloaded and to rotate so as for the periphery edge supporting portion to contact the periphery edge of the substrate at a closed position where the substrate is supported,
the target component is the chucks, and
the matching processing unit is configured to perform the matching at a timing set so as to operate in response to the chuck operation command.

8. The substrate treating apparatus according to claim 5, wherein
the spin chuck : (3) includes at its peripheral edge a plurality of chucks (9) each having a back face supporting portion for supporting a back face of the substrate and a periphery edge supporting portion erected outside of a rotation center of the back face supporting portion for supporting a periphery edge of the substrate,
the spin chuck (3) further includes a chuck drive mechanism (17) configured to rotate the plurality of chucks in response to a chuck operation command so as for the periphery edge supporting portion not to contact the periphery edge of the substrate at an open position where the substrate is loaded and unloaded and to rotate so as for the periphery edge supporting portion to contact the periphery edge of the substrate at a closed position where the substrate is supported,
the target component is the chucks (9), and
the matching processing unit is configured to perform the matching at a timing set so as to operate in response to the chuck operation command.

9. The substrate treating apparatus according to claim 7, wherein
the matching processing unit is configured to perform the matching only once at a position as the origin position where the chuck drive mechanism rotates each of the chucks to the closed position while the substrate is not placed on the chucks, and
the abnormality detecting unit is configured to set the normal information in accordance with the design information corresponding to the design shape matched at that time.

10. The substrate treating apparatus according to claim 8, wherein
the matching processing unit is configured to perform the matching only once at a position as the origin position where the chuck drive mechanism rotates each of the chucks to the closed position while the substrate is not placed on the chucks, and
the abnormality detecting unit is configured to set the normal information in accordance with the design information corresponding to the design shape matched at that time.

11. The substrate treating apparatus according to claim 3, further comprising:
a guard (23) configured to guard the spin chuck laterally; and
a guard moving mechanism (25) configured to move the guard upward and downward between an origin position where an upper end of the guard is low and a treating position where the upper end of the guard is higher than the origin position, wherein
the target component is the guard (23), and
the matching processing unit is configured to perform the matching at a timing set such that the guard is located at the treating position.

12. The substrate treating apparatus according to claim 11, wherein
the matching processing unit is configured to perform the matching only once at such a timing that the guard moving mechanism sets the guard to be located at the origin position, and
the abnormality detecting unit is configured to set the normal information in accordance with the design information corresponding to the design shape matched at that time.

13. The substrate treating apparatus according to claim 1, wherein
the matching processing unit is configured to perform the matching to the target component individually several times, and
the abnormality detecting unit is configured to detect an abnormality at each of the matching.

14. A substrate treating system comprising a plurality of substrate treating apparatus according to claim 1.

15. A substrate treating method for performing a predetermined treatment on a substrate, the method comprising:
an imaging step of capturing a real image including at least target components to be detected for an abnormality;
a matching processing step of determining which of the target components matches a real image shape as a two-dimensional shape in the real image in accordance with a degree of coincidence of feature points between the real image shape and a two-dimensional design shape based on three-dimensional design information about the target components; and
an abnormality detecting step of detecting an abnormality of a target component, matched in the matching processing step, through comparison between reality information about the matched target component based on the real image and normal information based on three-dimensional design information when the matched target component is normal.

## Patentansprüche

1. Substratbehandlungsvorrichtung (1) zum Durchführen einer vorbestimmten Behandlung an einem Substrat, wobei die Vorrichtung umfasst:
eine Gestaltungsinformations-Speichereinheit (57), die eingerichtet ist, dreidimensionale Gestaltungsinformationen über zumindest Zielkomponenten zu speichern, die auf eine Anomalie hin untersucht werden sollen;
eine Bildgebungseinheit (59), die eingerichtet ist, ein Realbild mit den Zielkomponenten aufzunehmen;
eine Abgleichsverarbeitungseinheit (61), die eingerichtet ist, zu bestimmen, welche der Zielkomponenten mit einer Realbildform als eine zweidimensionale Form in dem Realbild zusammenpasst, das durch die Bildgebungseinheit entsprechend einem Grad der Übereinstimmung von Merkmalspunkten zwischen der Realbildform und einer zweidimensionalen Gestaltungsform basierend auf dreidimensionalen Gestaltungsinformationen über die Zielkomponenten aufgenommen wurde; und
eine Anomalienerkennungseinheit (63), die eingerichtet ist, eine Anomalie einer Zielkomponente, die in der Abgleichsverarbeitungseinheit abgeglichen wurde, durch einen Vergleich zwischen Realitätsinformationen über die abgeglichene Zielkomponente basierend auf dem Realbild und Normalinformationen basierend auf dreidimensionalen Gestaltungsinformationen zu erkennen, wenn die abgeglichene Zielkomponente normal ist.

2. Substratbehandlungsvorrichtung gemäß Anspruch 1, wobei
die Anomalienerkennungseinheit (63) eingerichtet ist, die Normalinformationen basierend auf dreidimensionalen Gestaltungsinformationen der Zielkomponente einzustellen, wenn sich die Zielkomponente innerhalb einer Toleranz befindet, in der die Zielkomponente als normal akzeptiert wird.

3. Substratbehandlungsvorrichtung gemäß Anspruch 1, ferner umfassend:
ein Drehfutter (3), das eingerichtet ist, das Substrat in einer horizontalen Position zu halten und das Substrat zu drehen;
eine Düse (33), die eingerichtet ist, eine Behandlungsflüssigkeit von ihrem distalen Ende auf das von dem Drehfutter getragene Substrat auszustoßen; und
einen Düsenbewegungsmechanismus (35), der eingerichtet ist, das distale Ende der Düse zwischen einer Ursprungsposition, die seitlich von dem Substrat entfernt ist, und einer Ausstoßposition oberhalb des Substrats zu bewegen, wobei
die Zielkomponente die Düse ist, und
die Abgleichsverarbeitungseinheit das Abgleichen zu einem Zeitpunkt durchführt, der derart eingestellt ist, dass sich die Düse an der Ausstoßposition befindet.

4. Substratbehandlungsvorrichtung gemäß Anspruch 2, ferner umfassend:
ein Drehfutter (3), das eingerichtet ist, das Substrat in einer horizontalen Position zu halten und das Substrat zu drehen;
eine Düse (33), die eingerichtet ist, eine Behandlungsflüssigkeit von ihrem distalen Ende auf das von dem Drehfutter getragene Substrat auszustoßen; und
einen Düsenbewegungsmechanismus (35), der eingerichtet ist, das distale Ende der Düse zwischen einer Ursprungsposition, die seitlich von dem Substrat entfernt ist, und einer Ausstoßposition oberhalb des Substrats zu bewegen, wobei
die Zielkomponente die Düse ist, und
die Abgleichsverarbeitungseinheit eingerichtet ist, das Abgleichen zu einem Zeitpunkt durchzuführen, der derart eingestellt ist, dass sich die Düse an der Ausstoßposition befindet.

5. Substratbehandlungsvorrichtung gemäß Anspruch 3, ferner umfassend:
eine Düsenimpulsausgabeeinheit (43), die eingerichtet ist, einen Impuls auszugeben, wenn die Düse von der Ursprungsposition in die Ausstoßposition bewegt wird; und
eine Düsenbewegungssteuereinheit (51), die eingerichtet ist, den Düsenbewegungsmechanismus entsprechend dem Impuls von der Düsenimpulsausgabeeinheit zu steuern, wobei
die Düsenbewegungssteuereinheit eingerichtet ist, die Abgleichsverarbeitungseinheit zu veranlassen, das Abgleichen nur einmal zu einem solchen Zeitpunkt durchzuführen, dass der Düsenbewegungsmechanismus das distale Ende der Düse derart einstellt, dass es sich an der Ursprungsposition befindet, und eine Korrelation der Gestaltungsinformation, die der zu dem Zeitpunkt abgeglichenen Gestaltungsform entspricht, mit dem Impuls an der Ursprungsposition durchführt, und
die Anomalieerkennungseinheit eingerichtet ist, die Normalinformationen entsprechend der Korrelation und dem Impuls an der Ausstoßposition einzustellen.

6. Substratbehandlungsvorrichtung gemäß Anspruch 4, ferner umfassend:
eine Düsenimpulsausgabeeinheit (43), die eingerichtet ist, einen Impuls auszugeben, wenn die Düse von der Ursprungsposition in die Ausstoßposition bewegt wird; und
eine Düsenbewegungssteuereinheit (51), die eingerichtet ist, den Düsenbewegungsmechanismus entsprechend dem Impuls von der Düsenimpulsausgabeeinheit zu steuern, wobei
die Düsenbewegungssteuereinheit eingerichtet ist, die Abgleichsverarbeitungseinheit zu veranlassen, den Abgleich nur einmal zu einem solchen Zeitpunkt durchzuführen, dass der Düsenbewegungsmechanismus das distale Ende der Düse derart einstellt, dass es sich an der Ursprungsposition befindet, und eine Korrelation der Gestaltungsinformation, die der zu dem Zeitpunkt abgeglichenen Gestaltungsform entspricht, mit dem Impuls an der Ursprungsposition durchführt, und
die Anomalieerkennungseinheit eingerichtet ist, die Normalinformationen entsprechend der Korrelation und dem Impuls an der Ausstoßposition einzustellen.

7. Substratbehandlungsvorrichtung gemäß Anspruch 3, wobei
das Drehfutter (3) an seiner Umfangskante eine Vielzahl von Futtern (9) aufweist, die jeweils einen Rückseitenstützabschnitt zum Stützen einer Rückseite des Substrats und einen Umfangskantenstützabschnitt aufweisen, der außerhalb eines Rotationszentrums des Rückseitenstützabschnitts zum Stützen einer Umfangskante des Substrats errichtet ist,
das Drehfutter (3) ferner einen Futterantriebsmechanismus (17) aufweist, der eingerichtet ist, die Vielzahl von Futtern als Antwort auf einen Futter-Betriebsbefehl derart zu drehen, dass der Umfangskantenstützabschnitt die Umfangskante des Substrats in einer offenen Position, in der das Substrat geladen und entladen wird, nicht berührt, und derart zu drehen, dass der Umfangskantenstützabschnitt die Umfangskante des Substrats in einer geschlossenen Position, in der das Substrat gestützt wird, berührt,
die Zielkomponente das Futter ist, und
die Abgleichsverarbeitungseinheit eingerichtet ist, das Abgleichen zu einem Zeitpunkt durchzuführen, der derart eingestellt ist, dass er als Antwort auf den Futter-Betriebsbefehl erfolgt.

8. Substratbehandlungsvorrichtung gemäß Anspruch 5, wobei
das Drehfutter (3) an seiner Umfangskante eine Vielzahl von Futtern (9) aufweist, die jeweils einen Rückseitenstützabschnitt zum Stützen einer Rückseite des Substrats und einen Umfangskantenstützabschnitt aufweisen, der außerhalb eines Rotationszentrums des Rückseitenstützabschnitts zum Stützen einer Umfangskante des Substrats errichtet ist,
das Drehfutter (3) ferner einen Futter-Antriebsmechanismus (17) aufweist, der eingerichtet ist, die Vielzahl von Futtern als Antwort auf einen Futter-Betriebsbefehl derart zu drehen, dass der Umfangskantenstützabschnitt die Umfangskante des Substrats in einer offenen Position, in der das Substrat geladen und entladen wird, nicht berührt, und derart zu drehen, dass der Umfangskantenstützabschnitt die Umfangskante des Substrats in einer geschlossenen Position, in der das Substrat gestützt wird, berührt,
die Zielkomponente das Futter (9) ist, und
die Abgleichsverarbeitungseinheit eingerichtet ist, das Abgleichen zu einem Zeitpunkt durchzuführen, der derart eingestellt ist, dass er als Antwort auf den Befehl für den Futter-Betriebsbefehl erfolgt.

9. Substratbehandlungsvorrichtung gemäß Anspruch 7, wobei
die Abgleichsverarbeitungseinheit eingerichtet ist, das Abgleichen nur einmal an einer Position als der Ursprungsposition durchzuführen, an der der Futterantriebsmechanismus jedes der Futter in die geschlossene Position dreht, während das Substrat nicht auf den Futtern platziert ist, und
die Anomalieerkennungseinheit eingerichtet ist, die Normalinformationen entsprechend den Gestaltungsinformationen einzustellen, die der zu diesem Zeitpunkt angepassten Gestaltungsform entsprechen.

10. Substratbehandlungsvorrichtung gemäß Anspruch 8, wobei
die Abgleichsverarbeitungseinheit eingerichtet ist, das Abgleichen nur einmal an einer Position als der Ursprungsposition durchzuführen, an der der Futterantriebsmechanismus jedes der Futter in die geschlossene Position dreht, während das Substrat nicht auf den Futtern platziert ist, und
die Anomalieerkennungseinheit eingerichtet ist, die Normalinformationen entsprechend den Gestaltungsinformationen einzustellen, die der zu diesem Zeitpunkt angepassten Gestaltungsform entsprechen.

11. Substratbehandlungsvorrichtung gemäß Anspruch 3, ferner umfassend:
einen Schutz (23), der eingerichtet ist, das Drehfutter seitlich zu schützten; und
einen Schutzbewegungsmechanismus (25), der eingerichtet ist, den Schutz zwischen einer Ursprungsposition, in der ein oberes Ende des Schutzes niedrig ist, und einer Behandlungsposition, in der das obere Ende der Schutzeinrichtung höher als die Ursprungsposition ist, nach oben und nach unten zu bewegen, wobei
die Zielkomponente der Schutz (23) ist, und
die Abgleichsverarbeitungseinheit eingerichtet ist, das Abgleichen zu einem Zeitpunkt durchzuführen, der derart eingestellt ist, dass sich der Schutz an der Behandlungsposition befindet.

12. Substratbehandlungsvorrichtung gemäß Anspruch 11, wobei
die Abgleichsverarbeitungseinheit eingerichtet ist, das Abgleichen nur einmal zu einem solchen Zeitpunkt durchzuführen, dass der Schutzbewegungsmechanismus den Schutz derart einstellt, dass er sich an der Ursprungsposition befindet, und
die Anomalieerkennungseinheit eingerichtet ist, die Normalinformationen entsprechend den Gestaltungsinformationen einzustellen, die der zu diesem Zeitpunkt angepassten Gestaltungsform entsprechen.

13. Substratbehandlungsvorrichtung gemäß Anspruch 1, wobei
die Abgleichsverarbeitungseinheit eingerichtet ist, das Abgleichen mit der Zielkomponente individuell mehrmals durchzuführen, und
die Anomalienerkennungseinheit eingerichtet ist, eine Anomalie bei jedem Abgleich zu erkennen.

14. Substratbehandlungssystem, das eine Vielzahl von Substratbehandlungsvorrichtungen gemäß Anspruch 1 umfasst.

15. Substratbehandlungsverfahren zur Durchführung einer vorbestimmten Behandlung eines Substrats, wobei das Verfahren umfasst:
einen Bildgebungsschritt, zum Aufnehmen eines Realbilds zumindest mit Zielkomponenten, die auf eine Anomalie hin untersucht werden sollen;
einen Abgleichsverarbeitungsschritt zum Bestimmen, welche der Zielkomponenten mit einer Realbildform als zweidimensionale Form in dem Realbild übereinstimmt, entsprechend einem Grad der Übereinstimmung von Merkmalspunkten zwischen der Realbildform und einer zweidimensionalen Gestaltungsform, basierend auf dreidimensionalen Gestaltungsinformationen über die Zielkomponenten; und
einen Anomalienerkennungsschritt zum Erkennen einer Anomalie einer Zielkomponente, die in dem Abgleichsverarbeitungsschritt abgeglichen wurde, durch Vergleichen zwischen Realitätsinformationen über die abgeglichene Zielkomponente basierend auf dem Realbild und Normalinformationen basierend auf dreidimensionalen Gestaltungsinformationen, wenn die angepasste Zielkomponente normal ist.

## Revendications

1. Appareil de traitement de substrat (1) pour effectuer un traitement prédéterminé sur un substrat, l'appareil comprenant :
une unité de mémoire d'informations de conception (57) configurée pour stocker des informations de conception tridimensionnelles concernant au moins des composants cibles à détecter quant à une anomalie ;
une unité d'imagerie (59) configurée pour capturer une image réelle comportant les composants cibles ;
une unité de traitement de mise en correspondance (61) configurée pour déterminer lequel des composants cibles correspond à une forme d'image réelle en tant que forme bidimensionnelle dans l'image réelle capturée par l'unité d'imagerie conformément à un degré de coïncidence de points caractéristiques entre la forme d'image réelle et une forme de conception bidimensionnelle sur la base d'informations de conception tridimensionnelles concernant les composants cibles ; et
une unité de détection d'anomalie (63) configurée pour détecter une anomalie d'un composant cible, mis en correspondance dans l'unité de traitement de mise en correspondance, par comparaison entre des informations de réalité concernant le composant cible mis en correspondance basées sur l'image réelle et des informations normales basées sur des informations de conception tridimensionnelles lorsque le composant cible mis en correspondance est normal.

2. Appareil de traitement de substrat selon la revendication 1, dans lequel
l'unité de détection d'anomalie (63) est configurée pour établir les informations normales sur la base d'informations de conception tridimensionnelles du composant cible lorsque le composant cible est situé dans une tolérance où le composant cible est acceptable comme composant normal.

3. Appareil de traitement de substrat selon la revendication 1, comprenant en outre :
un mandrin rotatif (3) configuré pour supporter le substrat dans une posture horizontale et faire tourner le substrat ;
une buse (33) configurée pour éjecter un liquide de traitement depuis son extrémité distale vers le substrat supporté par le mandrin rotatif ; et
un mécanisme de déplacement de buse (35) configuré pour déplacer l'extrémité distale de la buse entre une position d'origine espacée latéralement du substrat et une position d'éjection au-dessus du substrat, dans lequel
le composant cible est la buse, et
l'unité de traitement de mise en correspondance effectue la mise en correspondance à un moment établi de sorte que la buse est située à la position d'éjection.

4. Appareil de traitement de substrat selon la revendication 2, comprenant en outre :
un mandrin rotatif (3) configuré pour supporter le substrat dans une posture horizontale et faire tourner le substrat ;
une buse (33) configurée pour éjecter un liquide de traitement depuis son extrémité distale vers le substrat supporté par le mandrin rotatif ; et
un mécanisme de déplacement de buse (35) configuré pour déplacer l'extrémité distale de la buse entre une position d'origine espacée latéralement du substrat et une position d'éjection au-dessus du substrat, dans lequel
le composant cible est la buse, et
l'unité de traitement de mise en correspondance est configurée pour effectuer la mise en correspondance à un moment établi de sorte que la buse est située à la position d'éjection.

5. Appareil de traitement de substrat selon la revendication 3, comprenant en outre :
une unité de sortie d'impulsion de buse (43) configurée pour délivrer en sortie une impulsion lorsque la buse est déplacée de la position d'origine à la position d'éjection ; et
une unité de commande de déplacement de buse (51) configurée pour commander le mécanisme de déplacement de buse conformément à l'impulsion provenant de l'unité de sortie d'impulsion de buse, dans lequel
l'unité de commande de déplacement de buse est configurée pour amener l'unité de traitement de mise en correspondance à effectuer la mise en correspondance une seule fois à un moment tel que le mécanisme de déplacement de buse établit l'extrémité distale de la buse pour qu'elle soit située à la position d'origine, et effectue une corrélation des informations de conception correspondant à la forme de conception mise en correspondance à ce moment avec l'impulsion à la position d'origine, et
l'unité de détection d'anomalie est configurée pour établir les informations normales conformément à la corrélation et l'impulsion à la position d'éjection.

6. Appareil de traitement de substrat selon la revendication 4, comprenant en outre :
une unité de sortie d'impulsion de buse (43) configurée pour délivrer en sortie une impulsion lorsque la buse est déplacée de la position d'origine à la position d'éjection ; et
une unité de commande de déplacement de buse (51) configurée pour commander le mécanisme de déplacement de buse conformément à l'impulsion provenant de l'unité de sortie d'impulsion de buse, dans lequel
l'unité de commande de déplacement de buse est configurée pour amener l'unité de traitement de mise en correspondance à effectuer la mise en correspondance une seule fois à un moment tel que le mécanisme de déplacement de buse établit l'extrémité distale de la buse pour qu'elle soit située à la position d'origine, et effectue une corrélation des informations de conception correspondant à la forme de conception mise en correspondance à ce moment avec l'impulsion à la position d'origine, et
l'unité de détection d'anomalie est configurée pour établir les informations normales conformément à la corrélation et l'impulsion à la position d'éjection.

7. Appareil de traitement de substrat selon la revendication 3, dans lequel
le mandrin rotatif (3) comporte au niveau de son bord périphérique une pluralité de mandrins (9) ayant chacun une partie de support de face arrière pour supporter une face arrière du substrat et une partie de support de bord périphérique érigée à l'extérieur d'un centre de rotation de la partie de support de face arrière pour supporter un bord périphérique du substrat,
le mandrin rotatif (3) comporte en outre un mécanisme d'entraînement de mandrins (17) configuré pour faire tourner la pluralité de mandrins en réponse à une instruction d'actionnement de mandrins de sorte que la partie de support de bord périphérique n'est pas en contact avec le bord périphérique du substrat au niveau d'une position ouverte où le substrat est chargé et déchargé et faire tourner de sorte que la partie de support de bord périphérique entre en contact avec le bord périphérique du substrat au niveau d'une position fermée où le substrat est supporté,
le composant cible est les mandrins, et
l'unité de traitement de mise en correspondance est configurée pour effectuer la mise en correspondance à un moment établi de manière à fonctionner en réponse à la l'instruction d'actionnement de mandrins.

8. Appareil de traitement de substrat selon la revendication 5, dans lequel
le mandrin rotatif (3) comporte au niveau de son bord périphérique une pluralité de mandrins (9) ayant chacun une partie de support de face arrière pour supporter une face arrière du substrat et une partie de support de bord périphérique érigée à l'extérieur d'un centre de rotation de la partie de support de face arrière pour supporter un bord périphérique du substrat,
le mandrin rotatif (3) comporte en outre un mécanisme d'entraînement de mandrins (17) configuré pour faire tourner la pluralité de mandrins en réponse à une instruction d'actionnement de mandrins de sorte que la partie de support de bord périphérique n'est pas en contact avec le bord périphérique du substrat au niveau d'une position ouverte où le substrat est chargé et déchargé et faire tourner de sorte que la partie de support de bord périphérique entre en contact avec le bord périphérique du substrat au niveau d'une position fermée où le substrat est supporté,
le composant cible est les mandrins (9), et
l'unité de traitement de mise en correspondance est configurée pour effectuer la mise en correspondance à un moment établi de manière à fonctionner en réponse à la l'instruction d'actionnement de mandrins.

9. Appareil de traitement de substrat selon la revendication 7, dans lequel
l'unité de traitement de mise en correspondance est configurée pour effectuer la mise en correspondance une seule fois à une position en tant que position d'origine où le mécanisme d'entraînement de mandrins fait tourner chacun des mandrins vers la position fermée tandis que le substrat n'est pas placé sur les mandrins, et
l'unité de détection d'anomalie est configurée pour établir les informations normales conformément aux informations de conception correspondant à la forme de conception mise en correspondance à ce moment.

10. Appareil de traitement de substrat selon la revendication 8, dans lequel
l'unité de traitement de mise en correspondance est configurée pour effectuer la mise en correspondance une seule fois à une position en tant que position d'origine où le mécanisme d'entraînement de mandrins fait tourner chacun des mandrins vers la position fermée tandis que le substrat n'est pas placé sur les mandrins, et
l'unité de détection d'anomalie est configurée pour établir les informations normales conformément aux informations de conception correspondant à la forme de conception mise en correspondance à ce moment.

11. Appareil de traitement de substrat selon la revendication 3, comprenant en outre :
un dispositif de protection (23) configuré pour protéger latéralement le mandrin rotatif ; et
un mécanisme de déplacement de dispositif de protection (25) configuré pour déplacer le dispositif de protection vers le haut et vers le bas entre une position d'origine où une extrémité supérieure du dispositif de protection est basse et une position de traitement où l'extrémité supérieure du dispositif de protection est plus haute que la position d'origine, dans lequel
le composant cible est le dispositif de protection (23), et
l'unité de traitement de mise en correspondance est configurée pour effectuer la mise en correspondance à un moment établi de sorte que le dispositif de protection est situé à la position de traitement.

12. Appareil de traitement de substrat selon la revendication 11, dans lequel
l'unité de traitement de mise en correspondance est configurée pour effectuer la mise en correspondance une seule fois à un moment tel que le mécanisme de déplacement de dispositif de protection établit le dispositif de protection pour qu'il soit située à la position d'origine, et
l'unité de détection d'anomalie est configurée pour établir les informations normales conformément aux informations de conception correspondant à la forme de conception mise en correspondance à ce moment.

13. Appareil de traitement de substrat selon la revendication 1, dans lequel
l'unité de traitement de mise en correspondance est configurée pour effectuer la mise en correspondance du composant cible individuellement plusieurs fois, et
l'unité de détection d'anomalie est configurée pour détecter une anomalie à chacune des mises en correspondance.

14. Système de traitement de substrat comprenant une pluralité d'appareils de traitement de substrat selon la revendication 1.

15. Méthode de traitement de substrat pour effectuer un traitement prédéterminé sur un substrat, la méthode comprenant :
une étape d'imagerie consistant à capturer une image réelle comportant au moins des composants cibles à détecter quant à une anomalie ;
une étape de traitement de mise en correspondance consistant à déterminer lequel des composants cibles correspond à une forme d'image réelle en tant que forme bidimensionnelle dans l'image réelle conformément à un degré de coïncidence de points caractéristiques entre la forme d'image réelle et une forme de conception bidimensionnelle sur la base d'informations de conception tridimensionnelles concernant les composants cibles ; et
une étape de détection d'anomalie consistant à détecter une anomalie d'un composant cible, mis en correspondance lors de l'étape de traitement de mise en correspondance, par comparaison entre des informations de réalité concernant le composant cible mis en correspondance basées sur l'image réelle et des informations normales basées sur des informations de conception tridimensionnelles lorsque le composant cible mis en correspondance est normal.
